(19) Europäisches Patentamt / European Patent Office / Office européen des brevets

(11) **EP 4 394 468 A1**

(12) **EUROPEAN PATENT APPLICATION**
published in accordance with Art. 153(4) EPC

(43) Date of publication:
**03.07.2024 Bulletin 2024/27**

(21) Application number: **22871739.3**

(22) Date of filing: **24.08.2022**

(51) International Patent Classification (IPC):
**G02B 6/42** (2006.01)     **H05K 7/20** (2006.01)

(52) Cooperative Patent Classification (CPC):
**G02B 6/42; H05K 7/20**

(86) International application number:
**PCT/CN2022/114591**

(87) International publication number:
**WO 2023/045686 (30.03.2023 Gazette 2023/13)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **24.09.2021   CN 202111124268
02.06.2022   CN 202210626425**

(71) Applicant: **Huawei Technologies Co., Ltd.
Shenzhen, Guangdong 518129 (CN)**

(72) Inventors:
• **LIN, Zhiyuan
Shenzhen, Guangdong 518129 (CN)**
• **SONG, Xiaolu
Shenzhen, Guangdong 518129 (CN)**
• **YU, Fei
Shenzhen, Guangdong 518129 (CN)**

(74) Representative: **Thun, Clemens
Mitscherlich PartmbB
Patent- und Rechtsanwälte
Karlstraße 7
80333 München (DE)**

(54) **OPTICAL MODULE AND OPTICAL COMMUNICATION DEVICE**

(57)     An optical module is provided, and includes a body (10) and at least one heat dissipation structure (20). The body (10) has a first end face (10a) and a second end face (10b). The first end face (10a) of the body (10) has at least one of an optical interface and an electrical interface, and the second end face (10b) is an end face facing opposite to the first end face (10a). The at least one heat dissipation structure (20) is located at least on the second end face (10b) and/or a side face (10c) of the body (10). Therefore, heat can be dissipated by using the heat dissipation structure (20) on a surface of the body (10), and heat dissipation effect of the optical module can be improved. In addition, a communication device including the optical module is further provided.

FIG. 1

**Description**

This application claims priority to Chinese Patent Application No. 202111124268.2, filed on September 24, 2021 and entitled "OPTICAL MODULE AND OPTICAL COMMUNICATION DEVICE", and to Chinese Patent Application No. 202210626425.8, filed on June 2, 2022 and entitled "OPTICAL MODULE AND OPTICAL COMMUNICATION DEVICE", both of which are incorporated herein by reference in their entireties.

**TECHNICAL FIELD**

This application relates to the field of optical communication technologies, and in particular, to an optical module and an optical communication device.

**BACKGROUND**

Optical modules are important components in optical fiber communication and are configured to perform conversion between optical signals and electrical signals. With rapid development of technologies such as cloud computing, big data, 5G, and autonomous driving, power of the optical modules increases, resulting in an increase in heat generation of the optical modules.

Heat dissipation of the optical module is usually performed by heat dissipation teeth located on an outer surface of the optical module. A heat dissipation capability of the heat dissipation tooth mainly depends on a surface area of the heat dissipation tooth. For the heat dissipation teeth have a same cross-sectional area, a longer heat dissipation tooth has a larger surface area and a stronger heat dissipation capability.

In an optical communication device, due to limited installation space, it is difficult to set a length of a heat dissipation tooth to be long. As a result, a surface area of the heat dissipation tooth is small, and a heat dissipation capability of the heat dissipation tooth is poor, affecting heat dissipation of the optical module.

**SUMMARY**

Embodiments of this application provide an optical module and an optical communication device, to overcome problems in conventional technologies. The technical solutions are as follows:

According to a first aspect, an embodiment of this application provides an optical module. The optical module includes a body and at least one heat dissipation structure, the body has a first end face and a second end face, the first end face of the body has at least one of an optical interface and an electrical interface, the second end face of the body is an end face facing opposite to the first end face, and the at least one heat dissipation structure is located at least on the second end face and/or a side face of the body. Therefore, heat can be dissipated by using the heat dissipation structure on a surface of the body, and heat dissipation effect of the optical module can be improved.

In some examples, the heat dissipation structure includes at least one heat dissipation tooth. In other examples, the heat dissipation structure includes at least one heat dissipation fin. In still some examples, the heat dissipation structure includes at least one heat dissipation tooth and at least one heat dissipation fin.

In some examples, the at least one heat dissipation structure is located at least on the second end face of the body. Based on the foregoing features, in this embodiment of this application, because the at least one heat dissipation structure is located at least on the second end face of the body, the heat dissipation structure located on the second end face is not limited by space, and arrangement space is large, so that the optical module can have a large heat dissipation area. This facilitates heat dissipation of the optical module.

In some examples, the heat dissipation structure is distributed on the side face of the body.

Based on the foregoing feature, although space on a side of the optical module is small when the optical module is installed, arranging the heat dissipation structure on the side face of the body in limited space helps make full use of the space to increase a total heat dissipation area of the optical module, thereby further improving heat dissipation effect of the optical module.

Optionally, the heat dissipation structure includes a plurality of heat dissipation teeth. A plurality of heat dissipation teeth located on a same surface of the body are distributed in an array. The body has a plurality of surfaces, a surface of the body includes the second end face and a plurality of side faces, and the plurality of heat dissipation teeth located on the same surface of the body refer to heat dissipation teeth located on the second end face or heat dissipation teeth located on a same side face. The heat dissipation teeth in arrays are neatly arranged, so that air can quickly flow between the heat dissipation teeth to take away heat.

In some examples, the heat dissipation structure further includes a bottom plate, the bottom plate is located on a surface of the body, and the heat dissipation teeth are connected to the bottom plate. A plurality of heat dissipation teeth are connected as a whole by disposing the bottom plate, so that the plurality of heat dissipation teeth are arranged on the body as a whole.

Optionally, at least a part of the plurality of heat dissipation teeth have a bent shape. For example, the heat dissipation teeth may be in a fold line shape, a curved line shape, and a streamline shape.

In some examples, a heat dissipation tooth with a bent shape is of a segmented structure, the heat dissipation tooth includes a first columnar part and a second columnar part, one end of the first columnar part is connected to the body, the other end of the first columnar part is connected to one end of the second columnar part, and an included angle exists between a length direction of the first columnar part and a length direction of the second columnar part. A length of a heat dissipation tooth with a fold line shape is a sum of a length of the first columnar part and a length of the second columnar part. The heat dissipation tooth is set to a fold line shape, so that the heat dissipation tooth has a large length, is away from another structure, and does not interfere with another structure adjacent to the heat dissipation tooth.

In other examples, the heat dissipation tooth is in a straight line shape.

Optionally, second columnar parts of at least a part of the heat dissipation teeth located on the side face of the body extend in a direction away from the first end face of the body. The second columnar parts of the heat dissipation teeth located on the side face of the body are arranged in this manner, so that the second columnar parts are away from the first end face of the body. This prevents the heat dissipation teeth from affecting installation of the optical module.

In some examples, second columnar parts of at least a part of the heat dissipation teeth located on a same surface of the body are connected. For example, second columnar parts of at least a part of the heat dissipation teeth located on the second end face are connected; and second columnar parts of at least a part of the heat dissipation teeth located on a same side face are connected.

A part of the heat dissipation teeth located on the same surface of the body are connected, so that an overall heat dissipation capability of the optical module can be further improved, and a temperature difference between different regions of the optical module can be reduced.

In other examples, second columnar parts of at least a part of the heat dissipation teeth located on adjacent surfaces of the body are connected. For example, a second columnar part of a heat dissipation tooth located on the side face is connected to a second columnar part of a heat dissipation tooth located on the second end face; and the second columnar parts of at least a part of the heat dissipation teeth located on the adjacent surfaces are connected. Heat dissipation teeth located on different surfaces are connected, so that an overall heat dissipation capability of the optical module can be further improved, and a temperature difference between different regions of the optical module can be reduced.

Optionally, the optical module further includes a front panel, and the front panel is connected to two opposite side faces of the body, and protrudes relative to the second end face. Two side faces that are connected to the front panel and that are on the body are defined as first side faces. The front panel is connected to the two first side faces, to prevent from touching the heat dissipation structure on the surface of the body when the optical module is plugged or unplugged, so that the optical module can be conveniently plugged or unplugged.

Optionally, heat dissipation teeth are distributed on a first side face of the body, the first side face is a side face that is of the body and that is connected to the front panel, and at least a part of the heat dissipation teeth located on the first side face have a bent shape. That a heat dissipation tooth has a bent shape means that the heat dissipation tooth has a curved shape, a fold line shape, and a straight line shape. To be specific, the bent shape is opposite to a straight line shape. For example, a heat dissipation tooth with a bent shape includes the foregoing heat dissipation tooth with a segmented structure. The heat dissipation tooth with the bent shape can be used to further increase a surface area in limited space, thereby improving heat dissipation effect of the optical module.

Optionally, the heat dissipation teeth that are located on the first side face and that have the bent shape partially overlap an orthographic projection of the front panel on the first side face, so that space of the body on one side of the first side face can be fully utilized, and surface areas of the heat dissipation teeth with the bent shape can be larger.

Optionally, the heat dissipation teeth are distributed on a side face of the body, each of at least a part of the heat dissipation teeth that are located on the first side face and that have a bent shape is of a segmented structure, and a second columnar part is located on a side that is of a first columnar part and that is close to the front panel.

Further, an orthographic projection, on the first side face, of a second columnar part of a heat dissipation tooth located on the first side face partially overlaps an orthographic projection part of the front panel on the first side face. Space of the first side face is fully utilized to extend the second columnar part, so that the heat dissipation tooth has a larger surface area for heat dissipation.

In some examples, a length direction of a second columnar part of a heat dissipation tooth located on the first side face is parallel to the first side face, and the second columnar part extends in any direction. An extension direction of the second columnar part is selected based on a size of space in which the optical module is actually disposed without affecting arrangement of another surrounding component, so that the optical module has good heat dissipation effect.

In some examples, a plurality of heat dissipation teeth located on the first side face are distributed on two sides of the front panel. Space on the first side face is fully utilized to arrange the heat dissipation teeth, so that the optical module has better heat dissipation effect.

In some other examples, a plurality of heat dissipation teeth located on the first side face are distributed only on a same side of the front panel.

Optionally, a second columnar part of a heat dissipation tooth located on one side of the front panel is connected to a second columnar part of a heat dissipation tooth located on the other side of the front panel.

In the foregoing structure, heat dissipation teeth located on two sides of the front panel are connected, to form a frame with the first side wall, and the front panel is located in the frame, so that a structure of the optical module is more compact.

In some examples, each of at least a part of the heat dissipation teeth located on the first side face further includes a third columnar part. The third columnar part is located on a side that is of the second columnar part and that is close to the first side face, and one end of the third columnar part is connected to a side wall of the second columnar part; and the heat dissipation structure is distributed on a surface of the front panel, and heat dissipation teeth located on the surface of the front panel are distributed with at least a part of third columnar parts in a stagger manner.

In the foregoing structure, the heat dissipation teeth are also disposed on the surface of the front panel, to further improve an overall heat dissipation capability of the optical module. In addition, the heat dissipation teeth on the surface of the front panel and at least a part of the third columnar parts are distributed in a stagger manner, so that both the heat dissipation teeth on the surface of the front panel and the third columnar parts can be set to be long, thereby further improving a heat dissipation capability of the optical module.

In some examples, at least one of first side faces of the body is provided with a protruding part, and the front panel is located between the protruding part and a first columnar part of a heat dissipation tooth on the first side face. The protruding part is used to increase a volume of the body, and is used to facilitate arrangement of an internal structure of the body, for example, facilitate arrangement of a circuit board inside the body.

In some examples, each of two first side faces of the body is provided with a protruding part, volumes of protruding parts located on the two first side faces are the same or different, and the volumes are specifically determined based on an actual design requirement of the optical module.

Optionally, each of at least a part of the heat dissipation teeth further includes at least one third columnar part, the third columnar part is located on a side that is of the second columnar part and that is close to or away from the body, and one end of the third columnar part is connected to a side wall of the second columnar part. The third columnar part is further disposed, so that the heat dissipation teeth have larger surface areas, thereby further improving a heat dissipation capability of the optical module. In addition, when the third columnar part is located on a side that is of the second columnar part and that is close to the body, space occupied by the optical module is reduced. This prevents the optical module from interacting with another nearby component during installation.

In some examples, the heat dissipation teeth further include a plurality of third columnar parts, a part of the plurality of third columnar parts are located on a side that is of the second columnar part and that is close to the body, and the other part of the third columnar parts are located on a side that is of the second columnar part and that is away from the body. When installation space is enough, the third columnar part is disposed on a side that is of the second columnar part and that is close to the body and on a side that is of the second columnar part and that is away from the body, so that the dissipation teeth have larger surface areas, to further improve a heat dissipation capability of the optical module.

Optionally, the heat dissipation structure includes a plurality of heat dissipation fins. A plurality of heat dissipation fins located on a same surface of the body are parallel. The heat dissipation fins are parallel to each other, so that airflow can quickly flow between adjacent heat dissipation fins.

In some examples, the heat dissipation structure further includes a bottom plate, the bottom plate is located on a surface of the body, and the heat dissipation fins are connected to the bottom plate. The plurality of heat dissipation fins are connected as a whole by disposing the bottom plate, so that the plurality of heat dissipation fins are arranged on the body as a whole.

In some examples, heat dissipation fins located on two adjacent surfaces of the body are connected. For example, a heat dissipation fin located on the side face is connected to a heat dissipation fin located on the second end face; and heat dissipation fins located on adjacent side faces are connected.

In a working process of the optical module, a temperature difference may exist between different heat dissipation fins. Different heat dissipation fins are connected, so that heat is exchanged between the heat dissipation fins. This helps further improve an overall heat dissipation capability of the optical module, and reduces a temperature difference between different regions of the optical module.

Optionally, the body includes a first segment and a second segment that are connected, the first end face is located in the first segment, the second end face is located in the second segment, and a cross section of the first segment is smaller than a cross section of the second segment. The first segment is used to connect the optical module. Because the second segment has a larger cross section, the second segment has a larger area to arrange the heat dissipation structure, to improve heat dissipation effect of the optical module.

Optionally, the body further includes a transition segment, and the transition segment is connected between the first segment and the second segment. A cross-sectional area of the transition segment is gradually changed from one end that is of the transition segment and that is connected to the first segment to one end that is of the transition segment and that is connected to the second segment, so that a shape of the surface of the body is continuous.

Optionally, the body of the optical module includes a housing and a heat-conducting plate. The heat-conducting plate is located in the housing, and the heat-conducting plate is connected to the housing. The heat-conducting plate is configured to conduct heat inside the body to the housing for dissipation.

In some examples, the housing is detachably connected to the heat-conducting plate. In some other examples, the housing and the heat-conducting plate are of an integrally formed structure. A detachable connection mode facilitates disassembly and assembly of the optical module and replacement of components. The integrally formed structure facilitates heat conduction inside the body to the surface of the body, and accelerates heat dissipation of the optical module.

In some examples, the housing has at least one first opening, and at least a part of the heat-conducting plate is located in the first opening. At least a part of the heat dissipation structure is located in the first opening and is located on a surface of the heat-conducting plate.

In the foregoing structure, the surface of the heat-conducting plate is exposed from the first opening, so that the heat dissipation structure can be directly disposed on the surface of the heat-conducting plate. Heat can be directly conducted from the heat-conducting plate to the heat dissipation structure located on the surface of the heat-conducting plate. This shortens a heat conduction path, and helps further improve an overall heat dissipation capability of the optical module.

In some examples, the heat dissipation structure is detachably connected to the heat-conducting plate. In some other examples, the heat dissipation structure and the heat-conducting plate are of an integrally formed structure. Different arrangement manners can meet different design requirements. Therefore, arranging the heat dissipation structure in a detachable manner is flexible, facilitates disassembly, assembly, and replacement of the heat dissipation structure, and facilitates reasonable adjustment of a location of the heat dissipation structure based on a heating situation. The heat dissipation structure and the heat-conducting plate are disposed as an integrally formed structure, so that heat of the heat-conducting plate is more easily conducted to the heat dissipation structure.

Optionally, at least a part of the heat dissipation structure is located on a surface of the housing, so that heat of the housing can be conducted to the heat dissipation structure.

In some examples, the heat dissipation structure is detachably connected to the housing. In some other examples, the heat dissipation structure and the housing are of an integrally formed structure. Different arrangement manners can meet different design requirements. Therefore, arranging the heat dissipation structure in a detachable manner is flexible, facilitates disassembly, assembly, and replacement of the heat dissipation structure, and facilitates reasonable adjustment of a location of the heat dissipation structure based on a heating situation. The heat dissipation structure and the housing are disposed as the integrally formed structure, so that heat of the housing is more easily conducted to the heat dissipation structure.

Optionally, an orthographic projection of the heat dissipation structure on a surface of the housing at least partially overlaps an orthographic projection of the heat-conducting plate on the surface of the housing. A temperature of a region in which the housing is in contact with the heat-conducting plate is usually high. Therefore, the heat dissipation structure is arranged in this manner, so that heat can be conducted to the heat dissipation structure more quickly, and an overall heat dissipation capability of the optical module can be improved.

Optionally, the body has an airflow channel, and a second opening of the airflow channel is located on the surface of the body. Airflow can flow through the inside of the body through the second opening on the surface of the body. In this way, heat of the optical module is taken away through the airflow, and a heat dissipation capability of the optical module can be further improved.

In some examples, the airflow channel has at least one second opening located in a region in which the heat dissipation structure is located. The second opening is arranged in the region in which the heat dissipation structure is located, and when airflow flows out of the second opening, a portion of heat is also taken away from a surface of a heat dissipation tooth or a heat dissipation fin close to the second opening through the airflow, thereby further accelerating a heat dissipation rate of the optical module.

Optionally, the airflow channel is located in the heat-conducting plate. A temperature of the heat-conducting plate is high. Therefore, a contact area between the heat-conducting plate and air is increased by disposing the airflow channel in the heat-conducting plate, so that airflow can take away heat of the heat-conducting plate more quickly, and a temperature of the optical module is reduced.

According to a second aspect, an embodiment of this application further provides an optical communication device, and the optical communication device includes an optical module connector and at least one optical module according to the foregoing aspect. Based on the foregoing feature, in this embodiment of this application, because at least one heat dissipation structure is located at least on a second end face of a body, the heat dissipation structure located on the second end face is not limited by space, and arrangement space is large, so that the optical module can have a large heat dissipation area. This facilitates heat dissipation of the optical module.

## BRIEF DESCRIPTION OF DRAWINGS

FIG. 1 is a schematic diagram of a structure of an optical module according to an embodiment of this application;

FIG. 2 is a schematic diagram of comparison of optical modules according to an embodiment of this application;

FIG. 3 is a schematic diagram of a structure of an optical module according to an embodiment of this application;

FIG. 4 is a schematic diagram of a structure of an optical module according to an embodiment of this application;

FIG. 5 is a schematic diagram of a structure of an optical module according to an embodiment of this application;

FIG. 6 is a schematic diagram of a structure of an optical module according to an embodiment of this application;

FIG. 7 is a schematic diagram of a structure of an optical module according to an embodiment of this application;

FIG. 8 is a schematic diagram of a structure of an optical module according to an embodiment of this application;

FIG. 9 is a schematic diagram of a structure of an optical module according to an embodiment of this application;

FIG. 10 is a schematic diagram of a structure of an optical module according to an embodiment of this application;

FIG. 11 is a schematic diagram of a structure of an optical module according to an embodiment of this disclosure;

FIG. 12 is a schematic diagram of a structure of an optical module according to an embodiment of this application;

FIG. 13 is a schematic diagram of a structure of an optical module according to an embodiment of this application;

FIG. 14 is a schematic diagram of a structure of an optical module according to an embodiment of this application;

FIG. 15 is a schematic diagram of a structure of an optical module according to an embodiment of this application;

FIG. 16 is a schematic diagram of a structure of an optical module according to an embodiment of this disclosure;

FIG. 17 is a schematic diagram of a structure of an optical module according to an embodiment of this disclosure;

FIG. 18 is a schematic diagram of a structure of an optical module according to an embodiment of this application;

FIG. 19 is a side view of an optical module according to an embodiment of this application;

FIG. 20 is a schematic diagram of a structure of an optical module according to an embodiment of this application;

FIG. 21 is a cross-sectional view of FIG. 20;

FIG. 22 is a schematic diagram of a structure of an optical module according to an embodiment of this application;

FIG. 23 is a cross-sectional view of FIG. 22;

FIG. 24 is a cross-sectional view of an optical module according to an embodiment of this application;

FIG. 25 is a schematic diagram of a structure of a body of an optical module according to an embodiment of this application;

FIG. 26 is a cross-sectional view of an optical module according to an embodiment of this application;

FIG. 27 is a schematic diagram of a structure of an optical module according to an embodiment of this application;

FIG. 28 is a schematic diagram of a structure of an optical module according to an embodiment of this application;

FIG. 29 is a schematic diagram of a structure of an optical module according to an embodiment of this application;

FIG. 30 is a schematic diagram of a structure of an optical module according to an embodiment of this application; and

FIG. 31 is a schematic diagram of an optical communication system according to an embodiment of this application.

## DESCRIPTION OF EMBODIMENTS

With rapid development of technologies such as cloud computing, big data, 5G, and autonomous driving, capacity of a switching node continues to increase, and power supply and heat dissipation of the node become bottlenecks. Moreover, various devices are deployed in a distributed mode, resulting in a large quantity of requirements for short-distance optical connections, and communication networks are also gradually developing towards miniaturization, high bandwidth, and low power consumption. Therefore, a high-power light source capable of meeting a target optical power requirement is required.

Target optical power is generally determined based on an optical power budget range of an optical link of a system in which an optoelectronic assembly, a light source pool, or an optoelectronic switching device is located, and is optical power that ensures that the system can be in a normal working state with a bit error rate less than a specific index. For example, to support normal working of four 100 Gpbs silicon photonic modulation links, a target optical power range of the optoelectronic assembly, the light source pool, or the optoelectronic switching device may be 50 mW to 150 mW, 64 mW to 120 mW, or 64 mW to 100 mW. For another example, to support normal working of eight 100 Gpbs silicon photonic modulation links, a target optical power range of the optoelectronic assembly, the light source pool, or the optoelectronic switching device may be 150 mW to 300 mW or 150 mW to 250 mW. Power consumption of the system should be as low as possible while ensuring that an optical power budget of the optical link of the system is met.

In a high-power (that is, output optical power is 18 dBm to 20 dBm) light source pool product, power consumption of a light source pool may reach 15 W. More than 50% of heat of the light source pool is centrally generated on a transmitter optical subassembly (transmission optical subassembly, TOSA). Heat density of the transmitter optical subassembly of the light source pool may be 2 to 5 times that of a quad small form factor pluggable-double density (quad small form factor pluggable-double density, QSFP-DD) module with same power consumption. Therefore, the transmitter optical subassembly needs a higher heat dissipation capability.

Generally, areas of heat dissipation teeth of an optical module may be increased, to increase a heat dissipation capability of the optical module. However, in a co-packaged optics (co-packaged optics, CPO) scenario, an on-board optics (on-board optics, OBO) scenario, or the like, due to limitation of a height of a panel and module interconnection, heat dissipation teeth on a side of the optical module are limited by space in a direction parallel to the panel. Therefore, it is difficult to expand areas of the heat dissipation teeth by increasing heights of the heat dissipation teeth. As a result, it is difficult to expand a heat dissipation area of the optical module, and it is difficult to improve a heat dissipation capability.

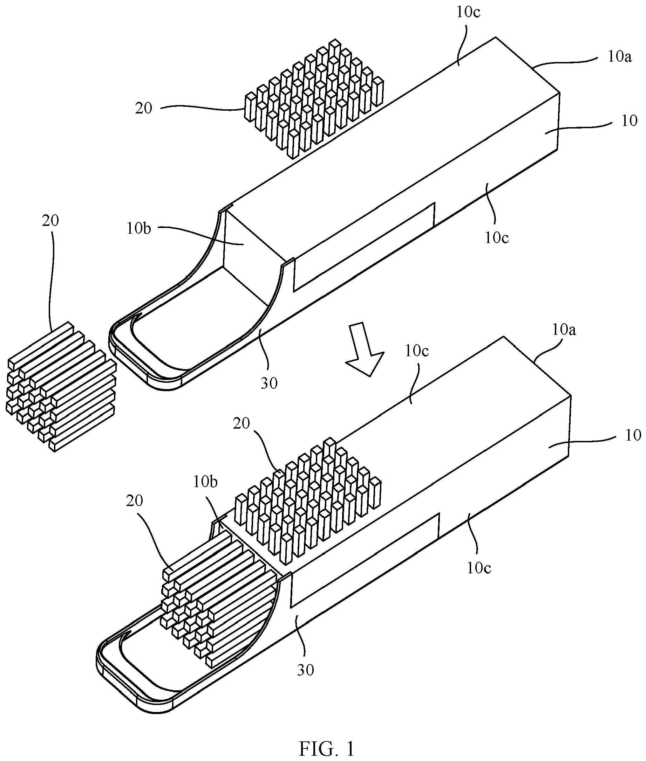

FIG. 1 is a schematic diagram of a structure of an optical module according to an embodiment of this application. As shown in FIG. 1, the optical module includes a body 10 and at least one heat dissipation structure 20. As an example, two heat dissipation structures 20 are shown in FIG. 1.

The body 10 has a first end face 10a and a second end face 10b, the first end face 10a of the body 10 has at least one of an optical interface and an electrical interface, and the first end face 10a is used to connect to an optical module connector. When the optical module is in use, one end of the body 10 is inserted into an optical cage, and the first end face 10a is an end face of the end that is of the body 10 and that is inserted into the optical cage. The optical module connector is located in the optical cage. When the optical module is inserted into the optical cage, the first end face 10a is connected to the optical module connector, and an interface located on the first end face 10a is connected to the optical module connector.

The second end face 10b of the body 10 is an end face facing opposite to the first end face 10a. That is, the second end face 10b is an end face of an end that is of the body 10 and that is located outside the optical cage after the body 10 is inserted into the optical cage. Both the optical interface and the electrical interface of the optical module are located outside the second end face 10b. The at least one heat dissipation structure 20 is located at least on the second end face 10b and/or on a side face 10c of the body 10.

The first end face 10a of the body 10 has at least one of the optical interface and the electrical interface, and the optical interface and the electrical interface are configured to perform conversion between optical signals and electrical signals. The optical cage is usually disposed on a circuit board, and generally, the optical module connector is provided at a tail of the optical cage. The optical module connector may be an optical connector, an electrical connector, or an optoelectronic connector. When the optical module is connected to the optical module connector, a part of the body 10 is inserted into the optical cage from a head of the optical cage, and the interface located on the first end face 10a cooperates with the optical module connector.

In a co-packaged optics (co-packaged optics, CPO) scenario, an on-board optics (on-board optics, OBO) scenario, or a case in which a plurality of optical modules are arranged close to each other, space on sides of the optical modules is limited, and a large heat dissipation structure cannot be arranged. As a result, a heat dissipation capability of the optical modules is poor. In this embodiment of this application, because the at least one heat dissipation structure 20 is located on the second end face 10b of the body 10, the heat dissipation structure 20 is not limited by space, and arrangement space is large, so that the optical module can have a large heat dissipation area. This facilitates heat dissipation of the optical module. The optical module can be used in a pluggable external light source pool or an external light source inside a board.

Optionally, the heat dissipation structure 20 includes at least one of a plurality of heat dissipation teeth and a plurality of heat dissipation fins. In other words, the heat dissipation structure 20 may be a set of the plurality of heat dissipation teeth, may be a set of the plurality of heat dissipation fins, or may be a set of the plurality of heat dissipation teeth and the plurality of heat dissipation fins. The heat dissipation tooth is columnar, and the heat dissipation fin is sheet-shaped. Both of the heat dissipation tooth and the heat dissipation fin have a large surface area, which can provide a large heat dissipation area. In some examples, the heat dissipation structure 20 may alternatively include only one heat dissipation tooth or one heat dissipation fin. In some cases in which space is very limited, even if there is only one heat dissipation tooth or heat dissipation fin, a heat dissipation capability of the optical module can be improved to some extent. In embodiments of this application, an example in which the heat dissipation structure 20 includes the plurality of heat dissipation teeth or the plurality of heat dissipation fins is used for description.

For ease of understanding, in embodiments of this application, an optical module with heat dissipation teeth and an optical module with heat dissipation fins are separately described. In some examples, the optical module may alternatively have heat dissipation teeth and heat dissipation fins.

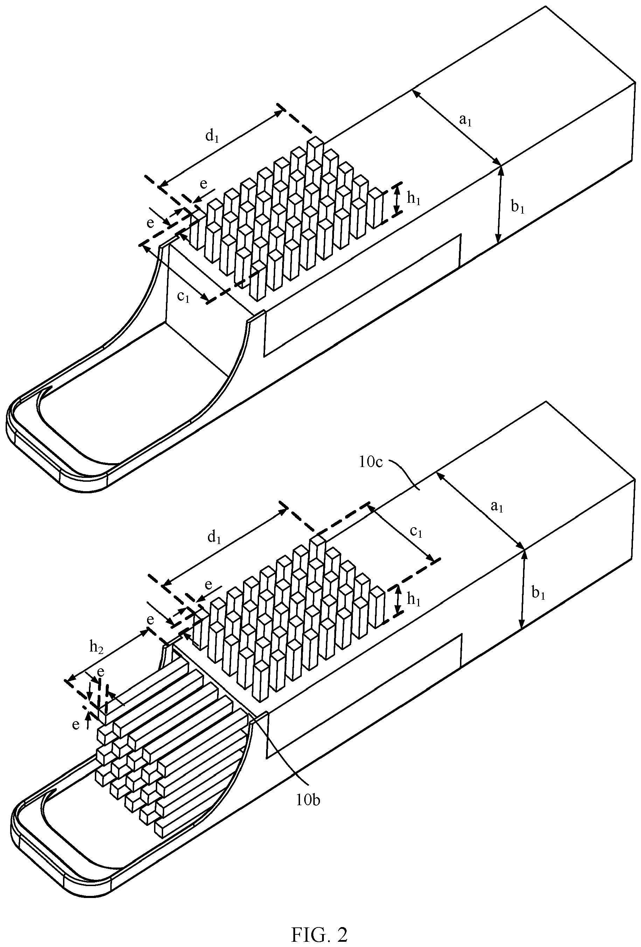

FIG. 2 is a schematic diagram of comparison of optical modules according to an embodiment of this application. An optical module in the upper part of FIG. 2 is an optical module in a conventional technology. When two optical modules are inserted into an optical cage, and exposed lengths of bodies of the two optical modules are the same, heat dissipation areas of the two optical modules are calculated respectively. For example, each of heat dissipation structures of the optical modules shown in FIG. 2 includes a plurality of heat dissipation teeth.

The optical module in the upper part has 40 heat dissipation teeth, and a heat dissipation area $S_1$ of the optical module is:

$$S_1 = a_1 \times b_1 + 4e \times h_1 \times 40 + a_1 \times d_1.$$

One side face 10c of an optical module in a lower part is provided with 40 heat dissipation teeth, a second end face 10b is provided with 20 heat dissipation teeth, and a heat dissipation area $S_2$ of the optical module is:

$$S_2 = 4e \times h_2 \times 20 + S_1.$$

For example, $a_1$ is 17 mm, $b_1$ is 15 mm, $c_1$ is 9 mm, $d_1$ is 15 mm, e is 1 mm, $h_1$ is 3 mm, and $h_2$ is 20 mm. In this case,

$$S_1 = 17 \times 15 + 4 \times 1 \times 3 \times 40 + 17 \times 15 = 990 \text{ mm}^2,$$

and

$$S_2 = 4 \times 1 \times 20 \times 20 + 990 = 2590 \text{ mm}^2.$$

In FIG. 2, a ratio of the heat dissipation area of the optical module in this embodiment of this application to the heat dissipation area of the optical module in the conventional technology is obtained, that is, 2.62, by comparing the heat dissipation areas of the two optical modules. Therefore, the heat dissipation area is significantly increased.

It should be noted that the foregoing comparison is only approximate calculation of the heat dissipation areas, and when the heat dissipation areas are calculated, because side areas of the bodies of the two optical modules are the same, the side areas are ignored to simplify the calculation, but this does not affect the conclusion that the heat dissipation area is significantly increased.

As shown in FIG. 1, the optical module includes two heat dissipation structures 20, and a heat dissipation structure 20 is also distributed on the side face 10c of the body 10. In this example, one of the two heat dissipation structures 20 is located on the second end face 10b of the body 10, and the other is located on one side face 10c of the body 10.

Although space on a side of the optical module is small when the optical module is installed, arranging the heat dissipation structure 20 on the side face 10c of the body 10 in limited space helps make full use of the space to increase a total heat dissipation area of the optical module, thereby further improving heat dissipation effect of the optical module. The body 10 has a columnar shape and has a plurality of side faces 10c in addition to the first end face 10a and the second end face 10b. Generally, the body 10 is roughly cuboid-shaped and has four side faces. In some examples, the heat dissipation structure 20 is disposed on one side face 10c of the body 10, and the side face 10c may be any one of the four side faces. In some other examples, the heat dissipation structure 20 is disposed on two side faces 10c of the body 10, and the two side faces 10c may be two opposite side faces 10c of the body 10, or may be two adjacent side faces 10c of the body 10. In other examples, the heat dissipation structure 20 is disposed on three or more side faces 10c of the body 10, or the heat dissipation structure 20 is disposed on each side face 10c.

In some examples, the optical module further includes a front panel 30, and the front panel 30 is connected to two side faces 10c of the body 10 and protrudes relative to the second end face 10b. Heat dissipation teeth 21 may be distributed on the side faces 10c connected to the front panel 30 of the body 10, or may be distributed on other side faces 10c. In addition, the heat dissipation structure 20 may be further distributed on a surface of the front panel 30, to further improve an overall heat dissipation capability of the optical module.

In some examples, the front panel 30 and the body 10 may be fixedly connected, detachably connected, or movably connected. For example, the front panel 30 may move relative to the body 10 along a length direction of the body 10. In this way, after the optical module is installed in place, the front panel 30 may be pushed in a direction close to the first end face 10a of the body 10, to reduce a length that is of the front panel 30 and that extends relative to the second end face 10b, and prevent the front panel 30 from interacting with another nearby component. For another example, when the optical module needs to be taken out, and the front panel is pulled in a direction away from the body 10 of the optical module, a location of the front panel relative to the body 10 may slide, to unlock the optical module from a mounting structure.

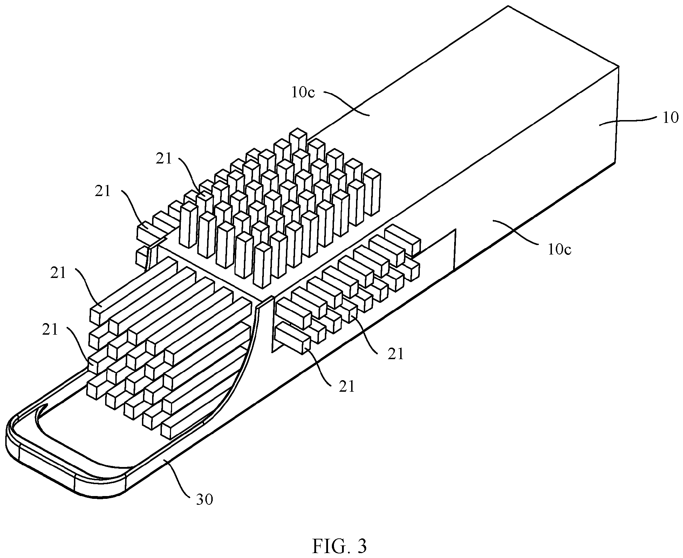

FIG. 3 is a schematic diagram of a structure of an optical module according to an embodiment of this application. As shown in FIG. 3, the heat dissipation structure 20 in the optical module includes a plurality of heat dissipation teeth 21. As shown in FIG. 3, a plurality of heat dissipation teeth 21 located on a same surface of a body 10 are distributed in an array. The body 10 has a plurality of surfaces, and the plurality of surfaces of the body 10 include the second end face 10b and a plurality of side faces 10c. Being located on a same surface of the body 10 means being located on the second end face 10b of the body 10 or being located on a same side face 10c of the body 10.

Heat generated by the body 10 is conducted to the heat dissipation teeth 21 through heat conduction, the plurality of heat dissipation teeth 21 are distributed on the plurality of surfaces of the body 10 in arrays, and when air flows between adjacent heat dissipation teeth 21, heat is taken away by the air from surfaces of the heat dissipation teeth 21, to reduce temperatures of the heat dissipation teeth 21. In this way, heat is continuously conducted from the body 10 to the heat dissipation teeth 21, to reduce a temperature of the body 10. Generally, the heat dissipation teeth 21 in arrays are neatly arranged, so that air can quickly flow between the heat dissipation teeth 21 to take away heat. In some examples, heat dissipation teeth 21 may also be randomly distributed. For example, the heat dissipation teeth 21 are designed to be arranged irregularly according to bionics, aerodynamics, or the like.

Distribution density of heat dissipation teeth 21 on different surfaces of the body 10 may be the same or different. Distribution density of heat dissipation teeth 21 on different regions on a same surface of the body 10 may also be the same or different. Distribution density of heat dissipation teeth 21 is a quantity of heat dissipation teeth 21 per unit area.

Distribution density of heat dissipation teeth 21 in a region in which a large amount of heat is output and that is of the body 10 is large, and distribution density of heat dissipation teeth 21 in a region in which a small amount of heat is output and that is of the body 10 is small. Because heat of heat dissipation teeth 21 needs to be taken away through air, there is a need to be a sufficient spacing between adjacent heat dissipation teeth 21, so that airflow can flow smoothly. It is not advisable that distribution density of heat dissipation teeth 21 is as large as possible. If the distribution density is excessively large, a spacing between adjacent heat dissipation teeth 21 may be excessively small, and air does not flow smoothly between the heat dissipation teeth 21. As a result, an overall heat dissipation capability of the optical module is reduced. When the optical module is designed, a working optical module may be detected by using a thermal imager, to obtain a thermal image of the optical module. Distribution density of heat dissipation teeth 21 in different regions on the surface of the body 10 is adjusted based on the thermal image, to reduce an overall temperature of the optical module, and prevent a local temperature of the optical module from being excessively high. In addition, a thermal simulation model may be used to simulate and analyze overall temperature distribution of the optical module, optimize and adjust the heat dissipation structure, and improve an overall heat dissipation capability.

Optionally, a shape of a cross section of a heat dissipation tooth 21 is a polygon, a circle, an ellipse, or another irregular pattern. Different shapes of cross sections of heat dissipation teeth 21 have different blocking effect on airflow, affecting flowing of airflow between the heat dissipation teeth 21. For example, in this embodiment of this application, a cross section of a heat dissipation tooth 21 is a square. When a flowing direction of airflow is perpendicular to one side face of the heat dissipation tooth 21, the flowing direction of the airflow is necessarily parallel to the other two side faces of the heat dissipation tooth 21. Therefore, the airflow can quickly pass between adjacent heat dissipation teeth 21. When the airflow is passing through, resistance on the airflow is excessively small, and the flowing direction of the airflow is not changed under action of the resistance. Therefore, turbulence does not occur.

Cross-sectional areas of heat dissipation teeth 21 on different surfaces of the body 10 or in different regions of a same surface may be the same or different. When lengths of heat dissipation teeth 21 are the same, a larger cross-sectional area of a heat dissipation tooth 21 indicates a larger surface area and a larger heat dissipation area of the heat dissipation tooth 21. However, a larger cross-sectional area of a single heat dissipation tooth 21 indicates a smaller specific surface area of the heat dissipation tooth 21, reducing a heat dissipation capability of the single heat dissipation tooth 21. This is because when heat is conducted from the body 10 to the heat dissipation tooth 21, not all of the heat is directly conducted to a surface of the heat dissipation tooth 21. Instead, a portion of the heat is conducted to the inside of the heat dissipation tooth 21, and then the portion of the heat is conducted from the inside of the heat dissipation tooth 21 to the surface of the heat dissipation tooth 21 and then taken away by air. A larger cross-sectional area of a heat dissipation tooth 21 indicates a slower speed at which heat inside the heat dissipation tooth 21 is conducted to a surface of the dissipation tooth 21 and a weaker heat dissipation capability. For a heat dissipation tooth 21 with a small cross-sectional area, although a single heat dissipation tooth 21 has a small surface area, the single dissipation tooth 21 also occupies small space. Therefore, a larger quantity of heat dissipation teeth 21 can be disposed in a same area. This may enhance an overall heat dissipation capability of the optical module.

For example, during design, a spacing between adjacent heat dissipation teeth 21 may be set to a fixed value, and then cross-sectional areas of the heat dissipation teeth 21 are adjusted, to determine cross-sectional areas that enable an overall heat dissipation capability of the optical module to meet a design requirement. Because amounts of heat generated in different regions of the optical module may be different, cross-sectional areas of heat dissipation teeth 21 located on different surfaces of the body 10 may be separately determined. In addition, on a same surface of the body 10, a plurality of regions may be obtained through division based on the thermal image, and a cross-sectional area of a heat dissipation tooth 21 in each region is determined separately, so that the cross-sectional area of the heat dissipation tooth 21 matches heat of a region in which the heat dissipation tooth 21 is located.

Optionally, a cross-sectional area of a heat dissipation tooth 21 is 0.04 mm$^2$ to 4 mm$^2$, and a cross-sectional area of a heat dissipation tooth 21 is preferably

0.25 mm$^2$ to 4 mm$^2$. Although a smaller cross-sectional area indicates a larger specific surface area of a heat dissipation tooth 21, the smaller cross-sectional area also indicates a higher difficulty in manufacturing the heat dissipation tooth 21 and higher costs of the heat dissipation tooth 21. In addition, a heat dissipation tooth 21 with an excessively small cross-sectional area has excessively small strength and is easy to break. A cross-sectional area of a heat dissipation tooth 21 is set within the foregoing range, that is, 0.25 mm$^2$ to 4 mm$^2$, so that the heat dissipation tooth 21 has a good heat dissipation capability, manufacturing costs of the heat dissipation tooth 21 are reasonable, and the heat dissipation tooth 21 is not easy to break.

A length of a heat dissipation tooth 21 also affects a heat dissipation capability of the heat dissipation tooth 21. When a cross-sectional area remains unchanged, a longer the heat dissipation tooth 21 indicates a larger surface area and a stronger heat dissipation capability of the heat dissipation tooth 21. However, when a length of a heat dissipation tooth 21 is excessively large, especially a heat dissipation tooth 21 located on a side face of the body 10, installation of the optical module may be affected. A length of the heat dissipation tooth 21 located on the side face of the body 10 may be set based on an installation environment of the optical module. When it is ensured that the optical module can be normally installed, the length of the heat dissipation tooth 21 is as long as possible, to improve a heat dissipation capability of the optical module. When the optical module is installed, installation of the optical module may be affected generally because space on a side of the optical module is limited. However, the second end face 10b of the body 10 is not limited by space. Therefore, a length of a heat dissipation tooth 21 located on the second end face 10b may be set to be long.

In some examples, a heat dissipation tooth 21 is columnar and straight, and the heat dissipation tooth 21 is in a straight line shape, for example, heat dissipation teeth 21 shown in FIG. 1 to FIG. 3. In other examples, a heat dissipation tooth 21 has a bent shape, bent is the opposite of straight, and the heat dissipation tooth 21 is in a fold line shape, a curved line shape, or a streamline shape.

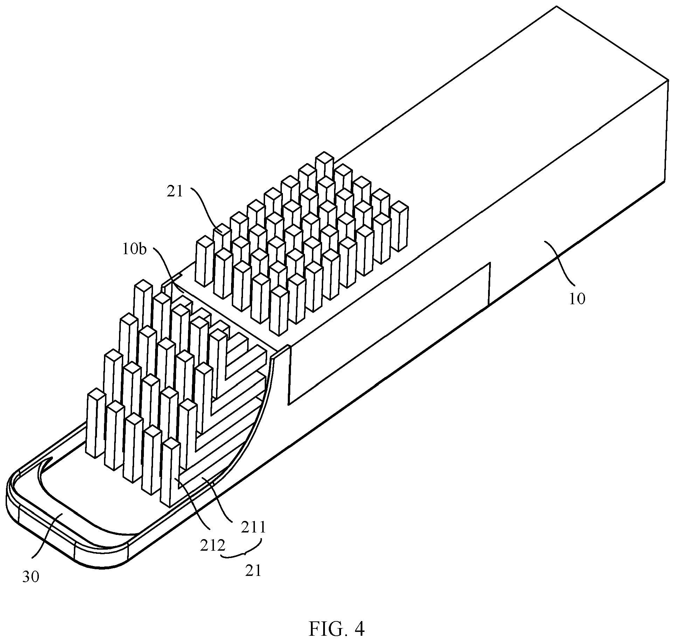

For example, FIG. 4 is a schematic diagram of a structure of an optical module according to an embodiment of this application. Each of at least a part of heat dissipation teeth 21 is of a segmented structure, that is, is in a fold line shape. As shown in FIG. 4, in the optical module, heat dissipation teeth 21 located on the second end face 10b include a first columnar part 211 and a second columnar part 212. One end of the first columnar part 211 is connected to the body 10, and the other end of the first columnar part 211 is connected to one end of the second columnar part 212. An included angle exists between a length direction of the first columnar part 211 and a length direction of the second columnar part 212.

The heat dissipation teeth 21 are set to the fold line shape, so that the heat dissipation teeth 21 have large lengths and do not interfere with another component located around the optical module. For a heat dissipation tooth 21 with a fold line shape, a length of the heat dissipation tooth 21 is a sum of a length of a first columnar part 211 and a length of a second columnar part 212. In some examples, the optical module further includes a front panel 30, the front panel 30 is connected to the body 10, the front panel 30 protrudes relative to the second end face 10b of the body 10, and the optical module can be pulled out from an optical cage by using the front panel 30. If the heat dissipation teeth 21 located on the second end face 10b are set to a straight line shape, using of the front panel may be affected when lengths of the heat dissipation teeth are long. If the heat dissipation teeth 21 located on the second end face 10b are set to a fold line shape, using of the front panel can be prevented from being affected, and lengths of the heat dissipation teeth 21 can be set to be long.

For example, in this embodiment of this application, the included angle between the length direction of the first columnar part 211 and the length direction of the second columnar part 212 is a right angle. In another example, the included angle between the length direction of the first columnar part 211 and the length direction of the second columnar part 212 may alternatively be an acute angle. Alternatively, the included angle between the length direction of the first columnar part 211 and the length direction of the second columnar part 212 may be an obtuse angle, provided that at least normal use of the front panel 30 is ensured.

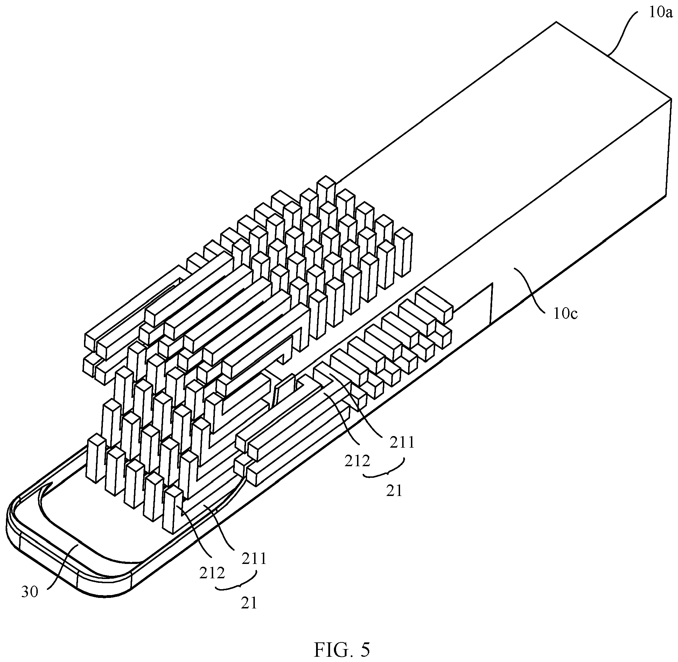

A heat dissipation tooth 21 with a fold line shape may be disposed on the second end face 10b of the body 10, and may also be disposed on the side face 10c of the body 10. This is not limited. For example, FIG. 5 is a schematic diagram of a structure of an optical module according to an embodiment of this application. As shown in FIG. 5, in the optical module, a part of heat dissipation teeth 21 located on three side faces 10c of the body 10 are in a fold line shape, and a part of the heat dissipation teeth 21 are in a straight line shape. Because space on a side of the optical module is limited, installation of the optical module may be affected. Therefore, heat dissipation teeth 21 on the side faces are set to a fold line shape, so that a heat dissipation capability of the optical module can be further improved without affecting the installation of the optical module.

In another example, heat dissipation teeth 21 on only one side face 10c or two side faces 10c may be in a fold line shape, and heat dissipation teeth 21 on other side faces may be in a straight line shape.

In another example, all heat dissipation teeth 21 located on a same side face of the body 10 may be heat dissipation teeth 21 with a fold line shape. Alternatively, a part of heat dissipation teeth 21 located on the second end face 10b may be in a fold line shape, and a part of the heat dissipation teeth 21 may be in a straight line shape.

As shown in FIG. 5, second columnar parts 212 of at least a part of heat dissipation teeth 21 located on the side face 10c of the body 10 extend in a direction away from the first end face 10a of the body 10.

When the optical module is installed, a part that is of the body 10 and that is close to the first end face 10a is inserted into an optical cage, so that an interface located on the first end face 10a is connected to an optical module connector. The second columnar parts 212 of the heat dissipation teeth 21 located on the side face 10c are arranged in the foregoing manner, so that the second columnar parts 212 are away from the first end face 10a of the body 10. This prevents the heat dissipation teeth 21 from affecting installation of the optical module.

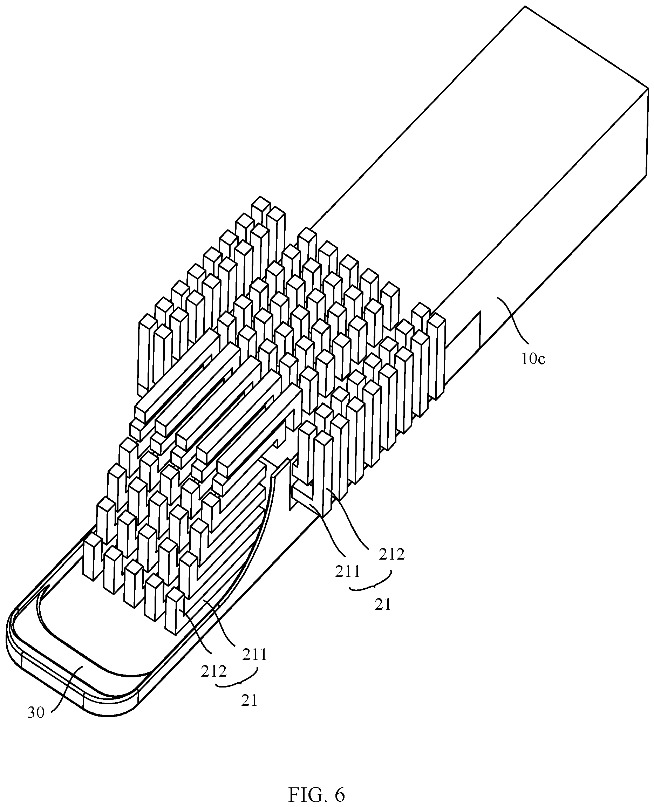

A length direction of a second columnar part 212 of a heat dissipation tooth 21 may be parallel to a surface of the body 10 on which the heat dissipation tooth 21 is located. For example, in FIG. 6, a length direction of a second columnar part 212 of a heat dissipation tooth 21 located on the side face 10c of the body 10 is parallel to the side face 10c of the body 10. Second columnar parts 212 of at least a part of heat dissipation teeth 21 located on a same surface may be coplanarly distributed.

In this embodiment of this application, a length direction of a second columnar part 212 of a heat dissipation tooth 21 located on the side face 10c of the body 10 is parallel to a length direction of the body 10. In another example, a length direction of a second columnar part 212 of a heat dissipation tooth 21 located on the side face 10c of the body 10 may not be parallel to a length direction of the body 10 For example, FIG. 6 is a schematic diagram of a structure of an optical module according to an embodiment of this application. As shown in FIG. 6, in the optical module, a length direction of a second columnar part 212 of a heat dissipation tooth 21 located on the side face 10c of the body 10 is perpendicular to a length direction of the body 10. In another example, an included angle between a length direction of a second columnar part 212 of a heat dissipation tooth 21 located on the side face 10c of the body 10 and a length direction of the body 10 may be an acute angle such as 30°, 45°, and 60°, or may be an obtuse angle. Second columnar parts 212 of heat dissipation teeth 21 located on a same side face 10c may be parallel to each other, or may not be parallel to each other. For example, along the length direction of the body 10, included angles between second columnar parts 212 of a plurality of heat dissipation teeth 21 and the length direction of the body 10 gradually change.

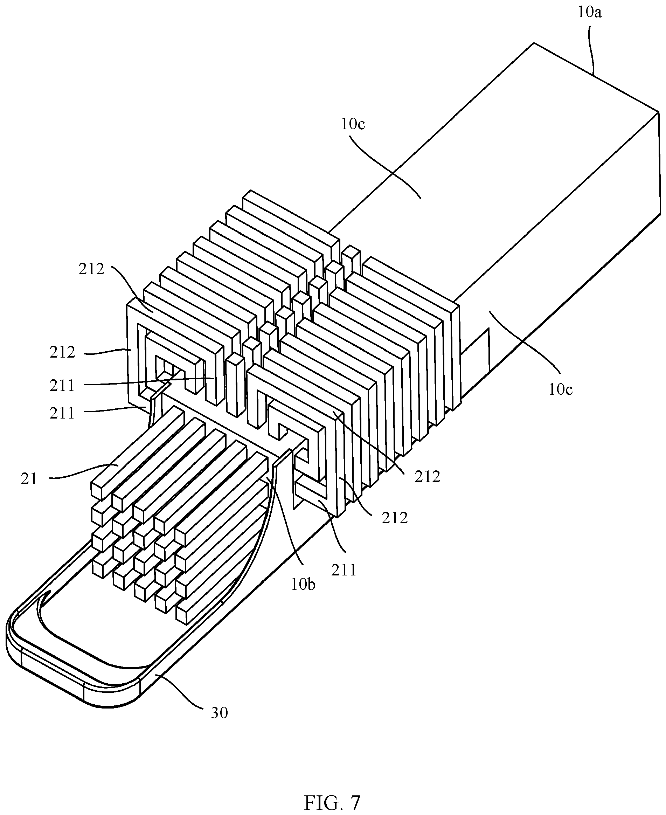

FIG. 7 is a schematic diagram of a structure of an optical module according to an embodiment of this application. As shown in FIG. 7, in the optical module, second columnar parts 212 of at least a part of heat dissipation teeth 21 located on adjacent surfaces of the body 10 are connected. In this example, heat dissipation teeth 21 located on adjacent side faces 10c of the body 10 are connected.

In a working process of the optical module, amounts of heat generated at different locations may be different, and different heat dissipation teeth 21 are located at different locations. Therefore, temperatures of different heat dissipation teeth 21 may be different. Different heat dissipation teeth 21 are connected, so that a heat dissipation tooth 21 with a high temperature can conduct a portion of heat to a heat dissipation tooth 21 with a low temperature, and the heat is dissipated by the heat dissipation tooth 21 with the low temperature. This helps further improve an overall heat dissipation capability of the optical module, and reduces a temperature difference between different regions of the optical module. In addition, heat dissipation teeth 21 extend, to connect to each other. This can further increase a heat dissipation area, and improve the heat dissipation capability of the optical module.

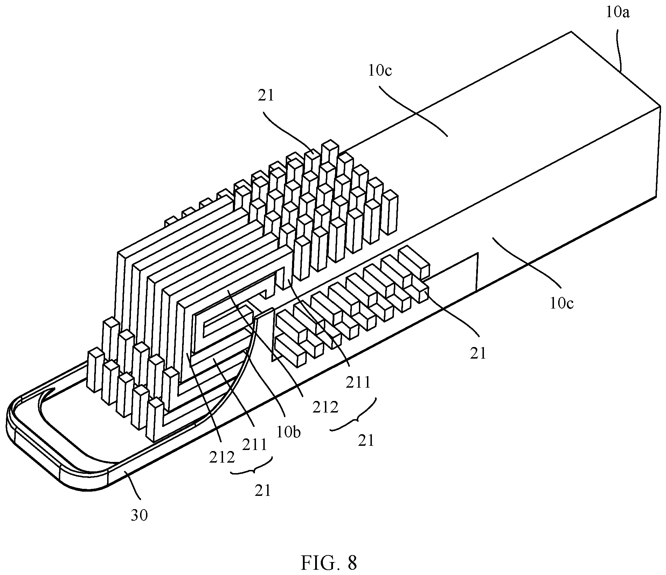

FIG. 8 is a schematic diagram of a structure of an optical module according to an embodiment of this application. As shown in FIG. 8, in the optical module, a second columnar part 212 of a heat dissipation tooth 21 located on the side face 10c of the body 10 is connected to a second columnar part 212 of a heat dissipation tooth 21 located on the second end face 10b of the body 10. In this way, in a working process of the optical module, a portion of heat is conducted from a heat dissipation tooth 21 with a high temperature to a heat dissipation tooth 21 with a low temperature, and then is dissipated by the heat dissipation tooth 21 with the low temperature. This further improves an overall heat dissipation capability of the optical module, and reduces a temperature difference between different regions of the optical module. In addition, heat dissipation teeth 21 extend, to connect to each other. This can further increase a heat dissipation area, and improve the heat dissipation capability of the optical module.

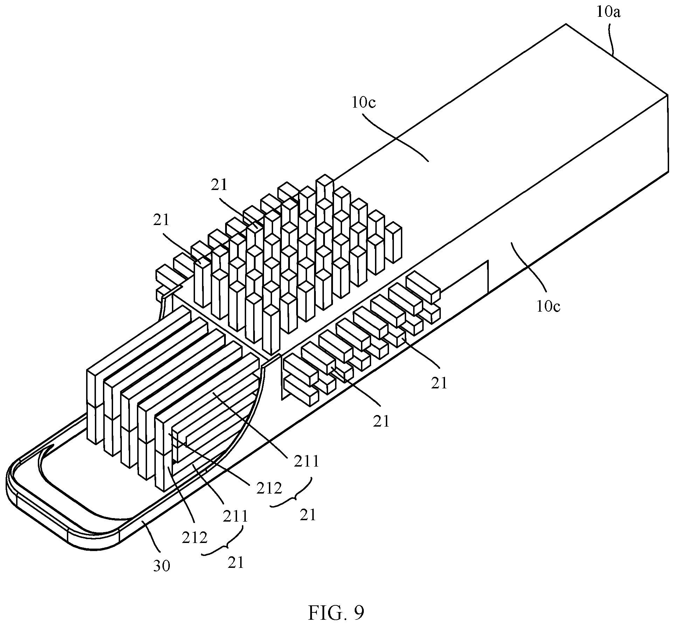

In some examples, second columnar parts 212 of at least a part of heat dissipation teeth 21 located on a same surface of the body 10 are connected. For example, FIG. 9 is a schematic diagram of a structure of an optical module according to an embodiment of this application. As shown in FIG. 9, in the optical module, second columnar parts 212 of at least a part of heat dissipation teeth 21 located on the second end face 10b of the body 10 are connected. In a working process of the optical module, amounts of heat generated in different regions on a same surface of the body 10 may be different. Therefore, heat dissipation teeth 21 located in different regions on the same surface of the body 10 may have a temperature difference. A part of the heat dissipation teeth 21 located on the same surface of the body 10 are connected, so that an overall heat dissipation capability of the optical module can be further improved, and a temperature difference between different regions of the optical module can be reduced. In addition, heat dissipation teeth 21 extend, to connect to each other. This can further increase a heat dissipation area, and improve the heat dissipation capability of the optical module.

In other examples, second columnar parts 212 of at least a part of heat dissipation teeth 21 located on a same side face of the body 10 are connected.

For example, in this embodiment of this application, end faces of two connected second columnar parts 212 completely overlap. In another example, end faces of two connected second columnar parts 212 may partially overlap, provided that heat can be exchanged through heat conduction by connecting the two second columnar parts 212 together.

When different heat dissipation teeth 21 are connected, two heat dissipation teeth 21 may be connected, or three or more heat dissipation teeth 21 may be connected. In the optical modules shown in FIG. 7 to FIG. 9, only a structure in which two heat dissipation teeth 21 are connected is used as an example.

Generally, when different heat dissipation teeth 21 are connected, heat dissipation teeth 21 in a same column or in a same row may be connected, or heat dissipation teeth 21 in different rows and in different columns may be connected, for example, heat dissipation teeth 21 located on a diagonal of an array are connected, or heat dissipation teeth 21 at any location may be connected. In the optical modules shown in FIG. 7 to FIG. 9, only a structure in which two heat dissipation teeth 21 in a same row or in a same column are connected is used as an example.

Optionally, heat dissipation teeth 21 are distributed on a first side face 10c' of the body 10, the first side face 10c' is a side face 10c that is connected to the front panel 30 and that is of the body 10, and at least a part of the heat dissipation teeth 21 on the first side face 10c' have a bent shape. The heat dissipation tooth 21 with the bent shape can be used to further increase a surface area in limited space, thereby improving heat dissipation effect of the optical module.

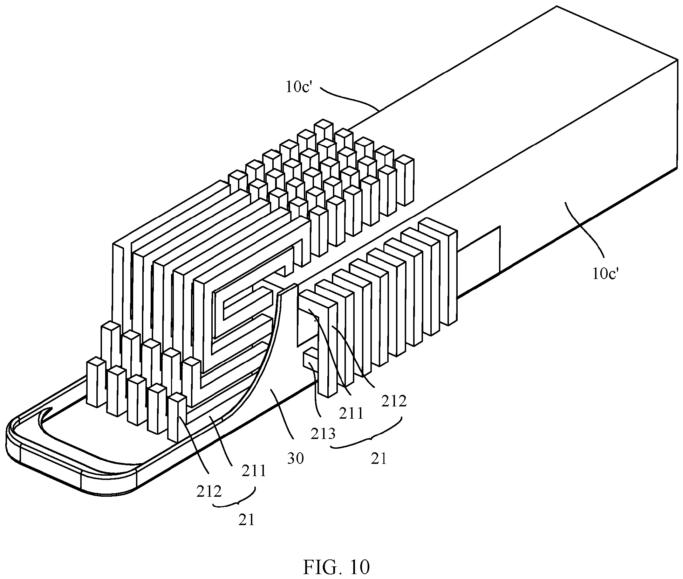

FIG. 10 is a schematic diagram of a structure of an optical module according to an embodiment of this application. As shown in FIG. 10, each of at least a part of the heat dissipation teeth 21 that are located on the first side face 10c' and that have a bent shape is of the foregoing segmented structure, and second columnar parts 212 of the heat dissipation teeth 21 with the segmented structure are located on a side that is of the first columnar part 211 and that is close to the front panel 30. The first side face 10c' is a side face 10c that is of the body 10 and that is connected to the front panel 30.

A heat dissipation tooth 21 that is located on the first side face 10c' and that has a bent shape partially overlaps an orthographic projection of the front panel 30 on the first side face 10c'. In this embodiment of this application, an orthographic projection, on the first side face 10c', of a second columnar part 212 of a heat dissipation tooth 21 located on the first side face 10c' overlaps the orthographic projection part of the front panel 30 on the first side face 10c'. In this way, space on both sides of the body 10 is fully utilized to arrange second columnar parts 212 of heat dissipation teeth 21. Therefore, not only the heat dissipation teeth 21 have larger surface areas for heat dissipation, but also heat dissipation teeth 21 located on the first side face 10c' are not easily interfered with another nearby component.

As shown in FIG. 10, each of at least a part of heat dissipation teeth 21 further includes at least one third columnar part 213, the third columnar part 213 is located on a side that is of the second columnar part 212 and that is close to the body 10, and one end of the third columnar part 213 is connected to a side wall of the second columnar part 212. The third columnar part 213 is disposed, to further increase a heat dissipation area of a heat dissipation tooth 21, and help improve overall heat dissipation effect of the optical module.

In another example, the third columnar part 213 may alternatively be located on a side that is of the second columnar part 212 and that is away from the body 10. Alternatively, a part of third columnar parts 213 are located on a side that is of the second columnar part 212 and that is close to the body 10, and a part of the third columnar parts 213 are located on a side that is of the second columnar part 212 and that is away from the body 10.

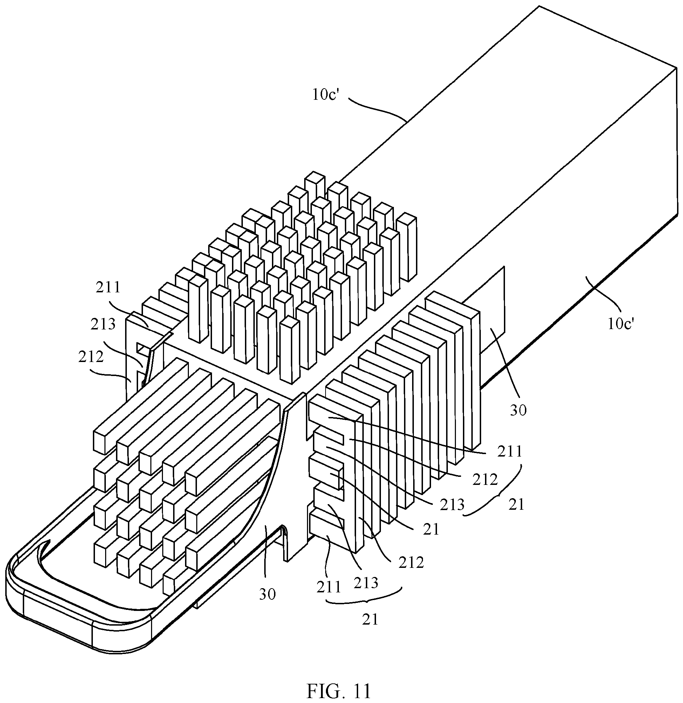

FIG. 11 is a schematic diagram of a structure of an optical module according to an embodiment of this disclosure. As shown in FIG. 11, a plurality of heat dissipation teeth 21 located on the first side face 10c' are distributed on two sides of the front panel 30. That is, a part that is of the front panel 30 and that is connected to the body 10 extends along the length direction of the body 10, and on the first side 10c', a plurality of heat dissipation teeth 21 are distributed on two sides of the part that is of the front panel 30 and that is connected to the body 10. Space on the first side face 10c' is fully utilized to arrange the heat dissipation teeth 21, so that the optical module has better heat dissipation effect.

Optionally, a second columnar part 212 of a heat dissipation tooth 21 on one side of the front panel 30 is connected to a second columnar part 212 of a heat dissipation tooth 21 on the other side of the front panel 30. In this way, heat dissipation teeth 21 located on both sides of the front panel 30 form a frame with the first side wall 10c', and the front panel 30 is located in the frame, so that an overall structure of the optical module is more compact. In a working process of the optical module, because amounts of heat generated at different locations of the first side face 10c' may be different, temperatures of the heat dissipation teeth 21 located on two sides of the front panel 30 may be different. The heat dissipation teeth 21 on the two sides of the front panel 30 are connected, so that a heat dissipation tooth 21 with a high temperature can conduct a portion of heat to a heat dissipation tooth 21 with a low temperature, and the heat is dissipated by the heat dissipation tooth 21 with the low temperature. This helps further improve an overall heat dissipation capability of the optical module, and reduces a temperature difference between different regions of the optical module.

As shown in FIG. 11, each of at least a part of heat dissipation teeth 21 located on the first side face 10c' further includes a third columnar part 213, the third columnar part 213 is located on a side that is of the second columnar part 212 and that is close to the first side face 10c', and one end of the third columnar part 213 is connected to a side wall of the second columnar part 212. The third columnar part 213 is disposed, to improve a heat dissipation capability of the optical module.

In addition, optionally, the heat dissipation structure 20 may also be distributed on a surface of the front panel 30. Optionally, heat dissipation teeth 21 located on the surface of the front panel 30 are distributed with at least a part of third columnar parts 213 in a stagger manner. The heat dissipation teeth 21 are also disposed on the surface of the front panel 30. This further improves an overall heat dissipation capability of the optical module. In addition, because the heat dissipation teeth 21 on the surface of the front panel 30 and the third columnar parts 213 are distributed in a stagger manner, both the heat dissipation teeth 21 on the surface of the front panel 30 and the third columnar parts 213 can be disposed to be long, to further improve the heat dissipation capability of the optical module.

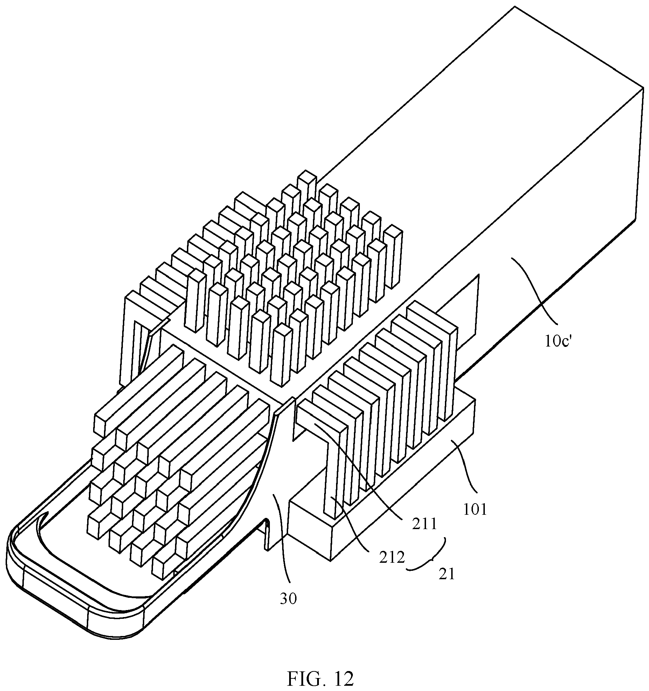

FIG. 12 is a schematic diagram of a structure of an optical module according to an embodiment of this application. As shown in FIG. 12, in the optical module, the body 10 has two protruding parts 101, the two protruding parts 101 are respectively located on two first side faces 10c', and the front panel 30 is located between the protruding part 101 and a first columnar part 211 of a heat dissipation tooth 21 on the first side face 10c'.

The two protruding parts 101 are used to increase a volume of the body 10, and also increase a surface area of the body 10. This facilitates heat dissipation of the body 10. In addition, increasing the volume of the body 10 can facilitate arrangement of an internal structure of the body 10. For example, a circuit board inside the body 10 may extend into two protruding parts 101. Therefore, a circuit board with a larger area can be arranged.

Volumes of the two protruding parts 101 may be the same or different. This is specifically determined by an actual design requirement of the optical module.

In another example, one first side face 10c' of the body 10 is provided with one protruding part 101, and the front panel 30 is located between the protruding part 101 and a first columnar part 211 of a heat dissipation tooth 21 on the first side face 10c'.

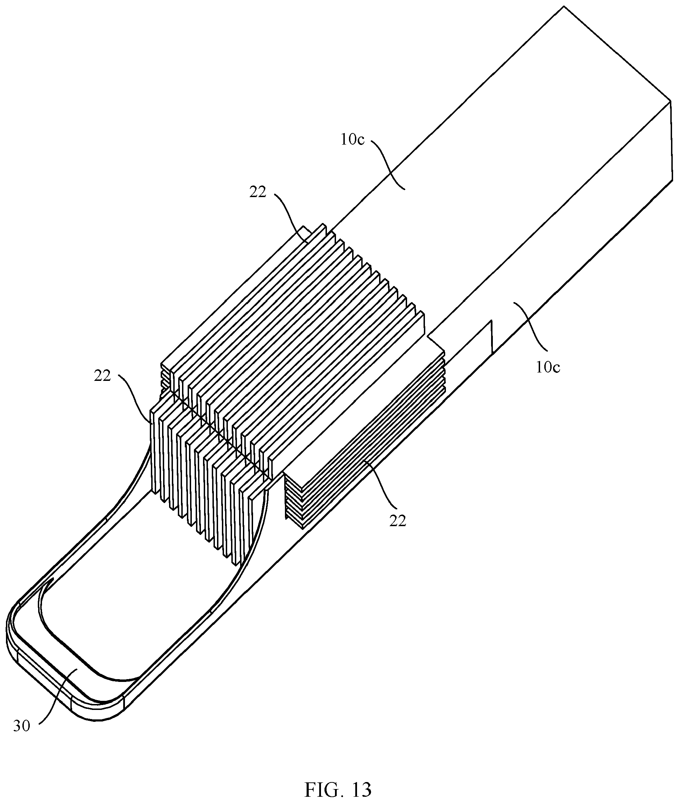

FIG. 13 is a schematic diagram of a structure of an optical module according to an embodiment of this application. As shown in FIG. 13, in the optical module, the heat dissipation structure 20 includes a plurality of heat dissipation fins 22, and the plurality of heat dissipation fins 22 are distributed in parallel. For example, FIG. 13 shows three heat dissipation structures 20, the three heat dissipation structures 20 are respectively located on the second end face 10b and two side faces 10c of the body 10, and a plurality of heat dissipation fins 22 located on a same surface of the body 10 are parallel.

On a same surface, a channel is formed between adjacent heat dissipation fins 22, and when airflow flows between the adjacent heat dissipation fins 22, heat is taken away from surfaces of the heat dissipation fins 22 through the airflow. Therefore, the heat is dissipated.

For example, in this embodiment of this application, the plurality of heat dissipation fins 22 located on the same surface are parallel. In another example, a plurality of heat dissipation fins 22 located on a same surface may not be parallel. In this embodiment of this application, an example in which a plurality of heat dissipation fins 22 located on a same surface are parallel is used.

In this embodiment of this application, a heat dissipation fin 22 located on the side face 10c of the body 10 extends along the length direction of the body 10. In another embodiment, a heat dissipation fin 22 located on the side face 10c of the body 10 may alternatively extend in another direction, for example, extend in a direction perpendicular to the length direction of the body 10. Extension directions of heat dissipation fins 22 on surfaces of the body 10 may be set based on an airflow direction in an optical communication device. A structure such as a fan for heat dissipation is usually disposed in the optical communication device, to accelerate air flow and dissipate heat for the optical communication device, so that an extension direction of a heat dissipation fin 22 is consistent with an airflow direction. This accelerates heat dissipation of the heat dissipation fin 22.

Optionally, a thickness of a heat dissipation fin 22 ranges from 0.2 mm to 2 mm. The heat dissipation fin 22 mainly dissipates heat through two surfaces with large areas, and the thickness of the heat dissipation fin 22 has little impact on a heat dissipation capability of the single heat dissipation fin 22. A smaller thickness of a heat dissipation fin 22 indicates smaller space occupied by the single heat dissipation fin 22 on a surface of the body 10. Therefore, a larger quantity of heat dissipation fins 22 can be disposed, and an overall heat dissipation capability of the optical module can be enhanced. However, if a thickness of a heat dissipation fin 22 is excessively small, manufacturing difficulty is increased, increasing costs. In addition, strength of the heat dissipation fin 22 is excessively low, and the heat dissipation fin 22 is easily damaged or broken. When a thickness of a heat dissipation fin 22 is set within the foregoing range, that is, 0.2 mm to 2 mm, manufacturing costs are reasonable, and the heat dissipation fin 22 is not easily damaged or broken.

In some examples, a plurality of heat dissipation fins 22 located on a same surface are arranged at equal spacings. In some other examples, in a plurality of heat dissipation fins 22 located on a same surface, spacings between some heat dissipation fins 22 are equal, and spacings between some heat dissipation fins 22 are unequal. In practice, a heat dissipation fin 22 may be designed based on an actual heat dissipation requirement and a heat dissipation environment of a module.

Because amounts of heat output in different regions of the optical module are different, spacings between heat dissipation fins 22 may be set based on amounts of heat output in different regions on a surface of the body 10. Spacings between heat dissipation fins 22 in a region in which a large amount of heat is output are small, and spacings between heat dissipation fins 22 in a region in which a small amount of heat is output are large.

Because heat of heat dissipation fins 22 needs to be taken away through air, there also needs to be a sufficient spacing between adjacent heat dissipation fins 22, so that airflow can flow smoothly. Although more heat dissipation fins 22 can be arranged in a unit area by arranging the heat dissipation fins 22 at small spacings, it is not advisable that spacings between the heat dissipation fins 22 are as small as possible. If the spacings are excessively small, air may not flow smoothly between the heat dissipation fins 22. As a result, an overall heat dissipation capability of the optical module is reduced. When the optical module is designed, a working optical module may be detected by using a thermal imager, to obtain a thermal image of the optical module. Spacings between heat dissipation fins 22 in different regions on the surface of the body 10 are adjusted based on the thermal image, to reduce an overall temperature of the optical module, and prevent a local temperature of the optical module from being excessively high. In addition, a thermal simulation model may be used to simulate and analyze overall temperature distribution of the optical module, optimize and adjust the heat dissipation structure, and improve an overall heat dissipation capability.

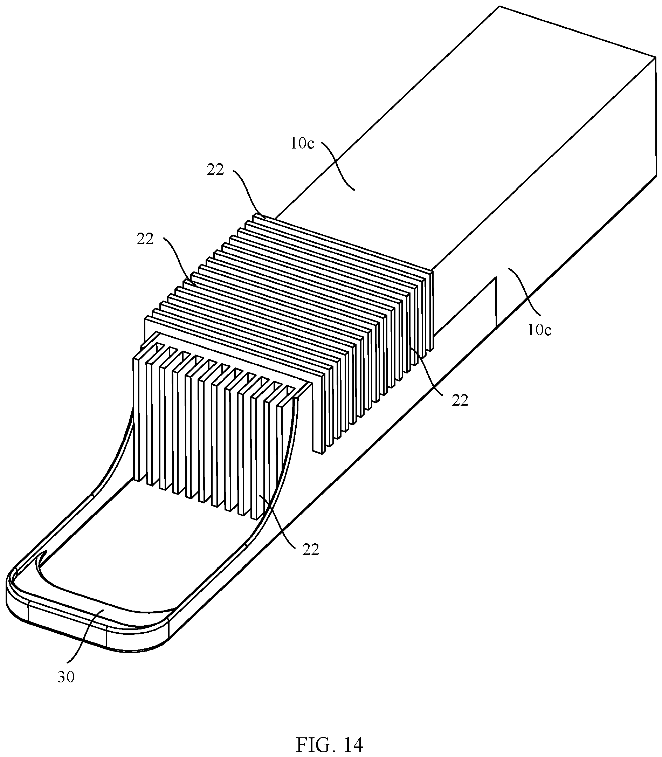

Optionally, heat dissipation fins 22 located on two adjacent surfaces of the body 10 are connected. FIG. 14 is a schematic diagram of a structure of an optical module according to an embodiment of this application. As shown in FIG. 14, in the optical module, heat dissipation fins 22 located on adjacent side faces 10c of the body 10 are connected. In a working process of the optical module, amounts of heat generated at different locations may be different, and different heat dissipation fins 22 are located at different locations. Therefore, temperatures of different heat dissipation fins 22 may be different. Different heat dissipation fins 22 are connected, so that a heat dissipation fin 22 with a high temperature can conduct a portion of heat to a heat dissipation fin 22 with a low temperature, and the heat is dissipated by the heat dissipation fin 22 with the low temperature. This helps further improve an overall heat dissipation capability of the optical module, and reduces a temperature difference between different regions of the optical module. In addition, connecting the heat dissipation fins 22 may further increase a heat dissipation area, and improve the heat dissipation capability of the optical module.

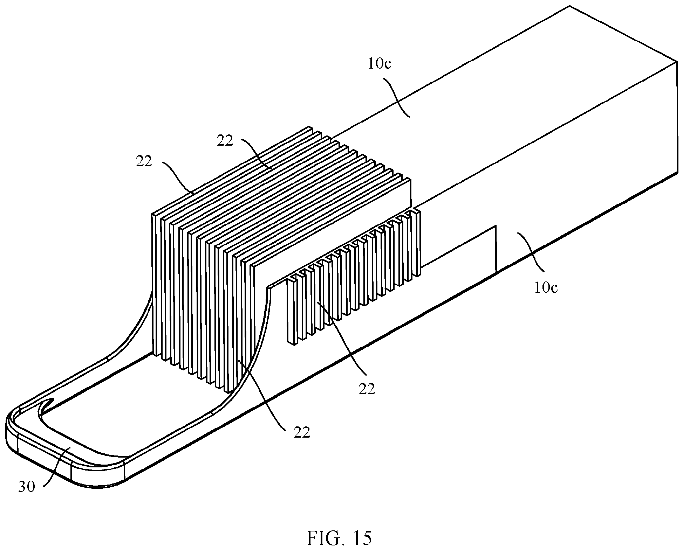

FIG. 15 is a schematic diagram of a structure of an optical module according to an embodiment of this application. As shown in FIG. 15, in the optical module, a heat dissipation fin 22 located on the side face 10c of the body 10 is connected to a heat dissipation fin 22 located on the second end face 10b. Similar to the optical module shown in FIG. 14, the optical module in this structure can further improve an overall heat dissipation capability of the optical module, and reduce a temperature difference between different regions of the optical module. In addition, connecting the heat dissipation fins 22 may further increase a heat dissipation area, and improve the heat dissipation capability of the optical module.

For example, connected heat dissipation fins 22 in this embodiment of this application are coplanar. In another example, connected heat dissipation fins 22 may alternatively be non-coplanar, provided that heat can be exchanged through heat conduction by connecting two heat dissipation fins 22 together.

In some examples, the optical module includes a plurality of heat dissipation structures 20, one heat dissipation structure 20 includes a plurality of heat dissipation teeth 21, and another heat dissipation structure 20 includes a plurality of heat dissipation fins 22, or one heat dissipation structure 20 includes both heat dissipation teeth 21 and heat dissipation fins 22. A heat dissipation tooth 21 and a heat dissipation fin 22 may be distributed on different surfaces of the body 10. For example, heat dissipation teeth 21 are distributed on the second end face 10b of the body 10, and heat dissipation fins 22 are distributed on the side face 10c of the body 10. Alternatively, a heat dissipation tooth 21 and a heat dissipation fin 22 may be distributed on a same surface of the body 10. For example, heat dissipation teeth 21 and heat dissipation fins 22 are distributed on the second end face 10b of the body 10, or heat dissipation teeth 21 and heat dissipation fins 22 are distributed on the side face 10c of the body 10.

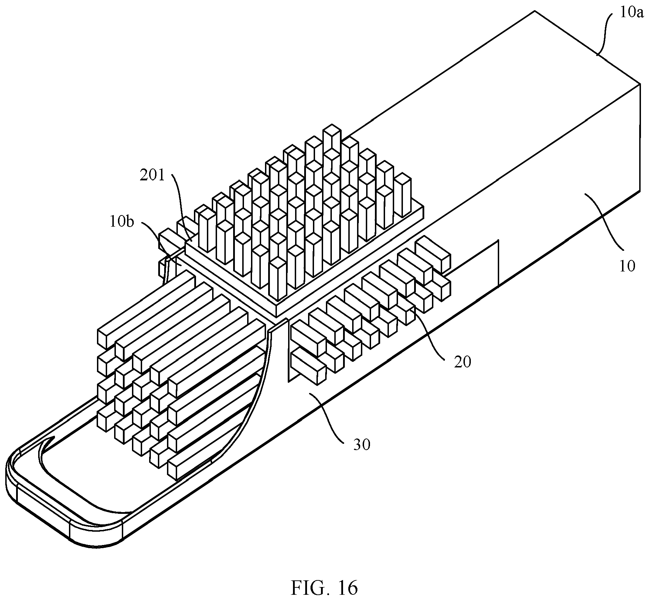

Optionally, the heat dissipation structure 20 may further include a bottom plate 201. For example, as shown in FIG. 16, the bottom plate 201 is located on a surface of the body 10, and heat dissipation teeth 21 are connected to the bottom plate 201. A plurality of heat dissipation teeth 21 are connected as a whole by disposing the bottom plate 201, so that the plurality of heat dissipation teeth 21 are conveniently arranged on the body 10 together. In addition, when the bottom plate 201 is disposed, a heat-conducting medium, for example, heat-conducting silicone grease, can be applied between the bottom plate 201 and the surface of the body 10, to further improve heat dissipation. In FIG. 16, only heat dissipation teeth 21 are used as an example. In another example, heat dissipation fins 22 may alternatively be connected to the bottom plate 201, and a plurality of heat dissipation fins 22 are connected as a whole, to facilitate installation.

In some examples, bottom plates 201 of heat dissipation structures 20 located on different surfaces of the body 10 may further be connected.

In this embodiment of this application, in addition to using the heat dissipation structure 20 to improve an overall heat dissipation capability of the optical module, the body 10 can be further used to improve the overall heat dissipation capability of the optical module.

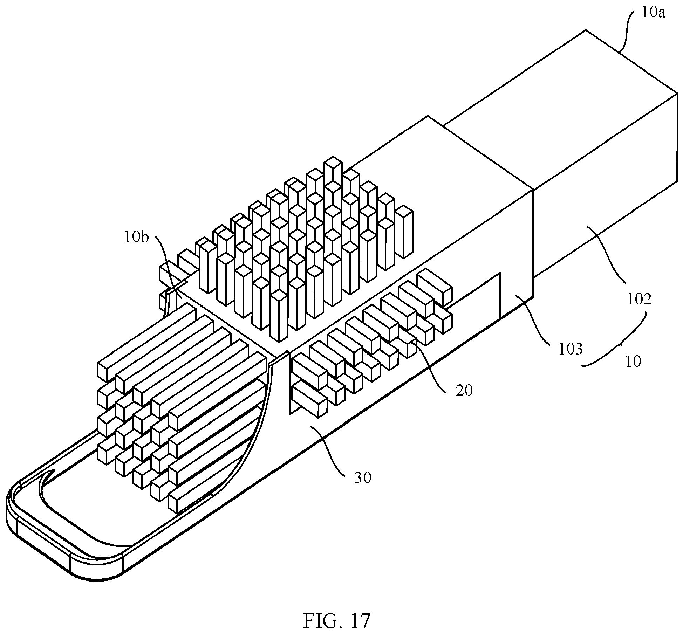

For example, FIG. 17 is a schematic diagram of a structure of an optical module according to an embodiment of this disclosure. As shown in FIG. 17, in the optical module, the body 10 includes a first segment 102 and a second segment 103 that are connected, the first end face 10a is located in the first segment 102, the second end face 10b is located in the second segment 103, and a cross section of the first segment 102 is smaller than a cross section of the second segment 103. The first segment 102 is used to connect the optical module. Because the second segment 103 has a larger cross section, the second segment 103 has a larger area to arrange the heat dissipation structure 20, to improve heat dissipation effect of the optical module.

Optionally, the body 10 may further include a transition segment, and the transition segment is connected between the first segment 102 and the second segment 103. A cross-sectional area of the transition segment is gradually changed from one end that is of the transition segment and that is connected to the first segment 102 to one end that is of the transition segment and that is connected to the second segment 103, so that a shape of the surface of the body 10 is continuous.

For example, a width of the cross section of the first segment 102 may be 18.35 mm, and a width of the cross section of the second segment 103 may be 22.58 mm. A width of a cross section may refer to a distance between two side faces connected to the main body 10 and the front panel 30. That is, the width of the cross section of the first segment 102 may be the same as a width of a QSFP (quad small form-factor pluggable, quad small form factor pluggable) optical module, and the width of the cross section of the second segment 103 may be the same as a width of an OSFP (octal small formfactor pluggable, octal small form factor pluggable) optical module.

In some other examples, a width of the cross section of the second segment 103 may be 22.35 mm, that is, slightly less than a width of an OSFP optical module. Alternatively, a width of the cross section of the first segment 102 is 22.58 mm, and a width of the cross section of the second segment 103 is 23.0 mm. The foregoing specific values of a width of the cross section of the first segment 102 and a width of the cross section of the second segment 103 are merely examples, and actual widths may be set based on a specific application scenario.

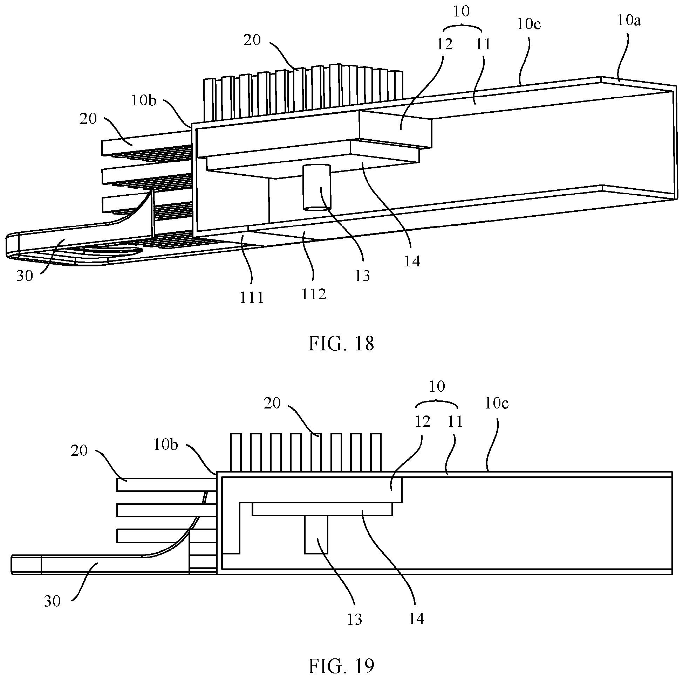

For another example, FIG. 18 is a schematic diagram of a structure of an optical module according to an embodiment of this application. In FIG. 18, a part of a structure of the body 10 is removed. As shown in FIG. 18, the body 10 of the optical module includes a housing 11 and a heat-conducting plate 12. The heat-conducting plate 12 is located in the housing 11, and the heat-conducting plate 12 is connected to the housing 11.

The heat-conducting plate 12 is detachably connected to the housing 11. For example, the heat-conducting plate 12 is connected to an inner wall of the housing 11 through a screw, a buckle, an adhesive, or the like. A detachable connection between the heat-conducting plate 12 and the housing 11 facilitates disassembly, assembly, and replacement of the heat-conducting plate 12, and arrangement is flexible.

Optionally, a heat-conducting coating is applied between the heat-conducting plate 12 and the inner wall of the housing 11, and the heat-conducting coating can be used to fill an air gap between the heat-conducting plate 12 and the housing 11, to promote heat exchange between the heat-conducting plate 12 and the housing 11, and further improve the heat dissipation capability of the optical module.

For example, the heat-conducting coating is heat-conducting silicone grease.

As shown in FIG. 18, the housing 11 includes a first housing 111 and a second housing 112, and the first housing 111 and the second housing 112 are detachably connected. When the optical module is assembled, the first housing 111 and the second housing 112 may be split, then an internal component of the optical module may be installed, and then the first housing 111 and the second housing 112 are assembled together. This facilitates disassembly and assembly of the optical module. The housing 11 is disposed to be detachable, and the first housing 111 and the second housing 112 may be made of a same material or different materials. In another example, the first housing 111 and the second housing 112 may alternatively be of an integrally formed structure, and cannot be detached.

The heat-conducting plate 12 is configured to dissipate heat for an internal component of the optical module. In an example, as shown in FIG. 18, the body 10 further includes a laser 13 and a cooler 14. The laser 13 is connected to the cooler 14, and the cooler 14 is connected to the heat-conducting plate 12. The cooler 14 is configured to: absorb heat generated by the laser 13, cool the laser 13, and conduct the heat to the heat-conducting plate 12.

For example, the cooler 14 may be a semiconductor cooler (thermo electric cooler, TEC). When the semiconductor cooler is in operation, a side that is of the semiconductor cooler and that is connected to the laser 13 absorbs heat, and a side that is of the semiconductor cooler and that is connected to the heat-conducting plate 12 releases the heat.

In the optical module shown in FIG. 18, the heat-conducting plate 12 is in a cuboid shape.

FIG. 19 is a side view of an optical module according to an embodiment of this application. In FIG. 19, a part of a structure of the body 10 is removed. As shown in FIG. 19, in the optical module, the heat-conducting plate 12 is in a step shape. A side face of the heat-conducting plate 12 is L-shaped, and a plurality of surfaces of the heat-conducting plate 12 are attached to an inner side wall of the housing 11. Compared with the heat-conducting plate 12 in FIG. 18, a contact area between the step-shaped heat-conducting plate 12 and the housing 11 is larger. This facilitates heat conduction.

A shape of the heat-conducting plate 12 may be designed based on arrangements of other components (for example, the cooler 14 and the laser 13) inside the optical module, so that a contact area between the heat-conducting plate 12 and the housing 11 is as large as possible without affecting the arrangements of the other components inside the optical module. A larger contact area between the heat-conducting plate 12 and the housing 11 is more conducive to conducting heat of the heat-conducting plate 12 to the housing 11, thereby improving a heat dissipation capability of the optical module.

The optical module shown in FIG. 19 is used as an example, and the heat dissipation structure 20 is located on a surface of the housing 11. Heat inside the body 10 is conducted to the housing 11, and then the heat is conducted from the housing 11 to the heat dissipation structure 20.

Optionally, an orthographic projection of the heat dissipation structure 20 on the surface of the housing 11 at least partially overlaps an orthographic projection of the heat-conducting plate 12 on the surface of the housing 11.

For example, as shown in FIG. 19, an orthographic projection, on a side face of the housing 11, of the heat dissipation structure 20 located on the side face 10c of the body 10 is located in an orthographic projection of the heat-conducting plate 12 on the side face of the housing 11. A part of an orthographic projection, on an end face of the housing 11, of the heat dissipation structure 20 located on the second end face 10b of the body 10 is located in an orthographic projection of the heat-conducting plate 12 on the end face of the housing 11, and the other part of the orthographic projection is located outside the orthographic projection of the heat-conducting plate 12 on the end face of the housing 11. A region in which a temperature is high and that is on the surface of the housing 11 is mainly a region in contact with the heat-conducting plate 12. Therefore, the heat dissipation structure 20 is arranged in the foregoing manner, so that heat can be conducted to the heat dissipation structure 20 more quickly. This helps improve an overall heat dissipation capability of the optical module.

In some examples, the heat dissipation structure 20 is detachably connected to the housing 11. For example, the heat dissipation structure 20 is connected to the surface of the housing 11 through a screw, a buckle, an adhesive, or the like. A detachable connection between the heat dissipation structure 20 and the housing 11 facilitates disassembly, assembly, and replacement of the heat dissipation structure 20. In addition, the heat dissipation structure 20 can be reasonably arranged based on a heating situation of the optical module. Therefore, arrangement is flexible.

Optionally, a heat-conducting coating is applied between the heat dissipation structure 20 and the surface of the housing 11, and the heat conduction coating can be used to fill an air gap between the heat dissipation structure 20 and the surface of the housing 11, to promote heat exchange between the housing 11 and the heat dissipation structure 20, and further improve the heat dissipation capability of the optical module.

In some other examples, the heat dissipation structure 20 and the housing 11 are of an integrally formed structure.

The heat dissipation structure 20 and the housing 11 are designed as the integrally formed structure, so that heat can be conducted from the housing 11 to the heat dissipation structure 20 more quickly.

Optionally, both the heat dissipation structure 20 and the housing 11 are made of a metal material, for example, metal copper, metal aluminum, copper alloy, aluminum alloy, and the like. Copper, aluminum, copper alloy, and aluminum alloy all have good ductility, are convenient to process, and have high thermal conductivity. This is beneficial to heat dissipation of the optical module.

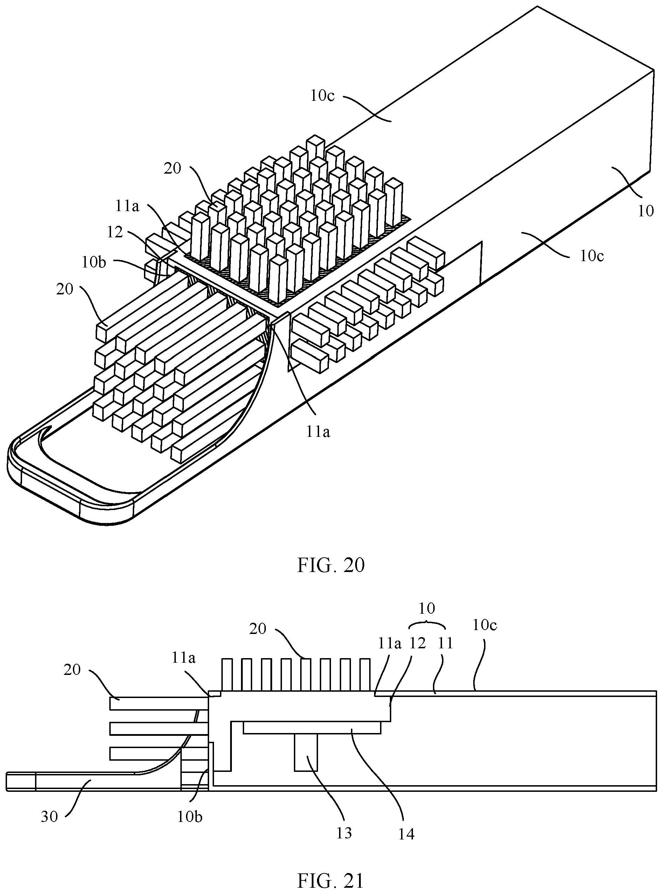

FIG. 20 is a schematic diagram of a structure of an optical module according to an embodiment of this application. FIG. 21 is a cross-sectional view of FIG. 20. As shown in FIG. 20 and FIG. 21, in the optical module, the housing 11 has two first openings 11a, and at least a part of the heat-conducting plate 12 is located in the first openings 11a. The heat dissipation structure 20 is located in the first opening 11a, and is located on a surface of the heat-conducting plate 12. In FIG. 20, a surface that is of the heat-conducting plate 12 and that is located in the first opening 11a is shown by using a filled region.

The surface of the heat-conducting plate 12 is exposed by disposing the first opening 11a on the housing 11, so that the heat dissipation structure 20 can be directly arranged on the surface of the heat-conducting plate 12. During heat dissipation, heat can be directly conducted from the heat-conducting plate 12 to the heat dissipation structure 20 located on the surface of the heat-conducting plate 12 without passing through the housing 11. This shortens a heat conduction path, and helps further improve an overall heat dissipation capability of the optical module. In addition, the exposed surface of the heat-conducting plate 12 is in contact with external air, and airflow can directly take a portion of heat away from the surface of the heat-conducting plate 12. This further improves the overall heat dissipation capability of the optical module.

In the optical module shown in FIG. 20, the housing 11 has two first openings 11a, one of the two first openings 11a is located on a side wall of the housing 11, and the other is located on an end part of the housing 11.

In some other examples, each first opening 11a is located on the side wall of the housing 11, and a surface that is of the heat-conducting plate 12 and that is located in the first opening 11a forms a part of the side face 10c of the body 10. In some other examples, each first opening 11a is located at the end part of the housing 11, and a surface that is of the heat-conducting plate 12 and that is located in the first opening 11a forms a part of the second end face 10b of the body 10. In addition, the housing 11 may have only one first opening 11a.

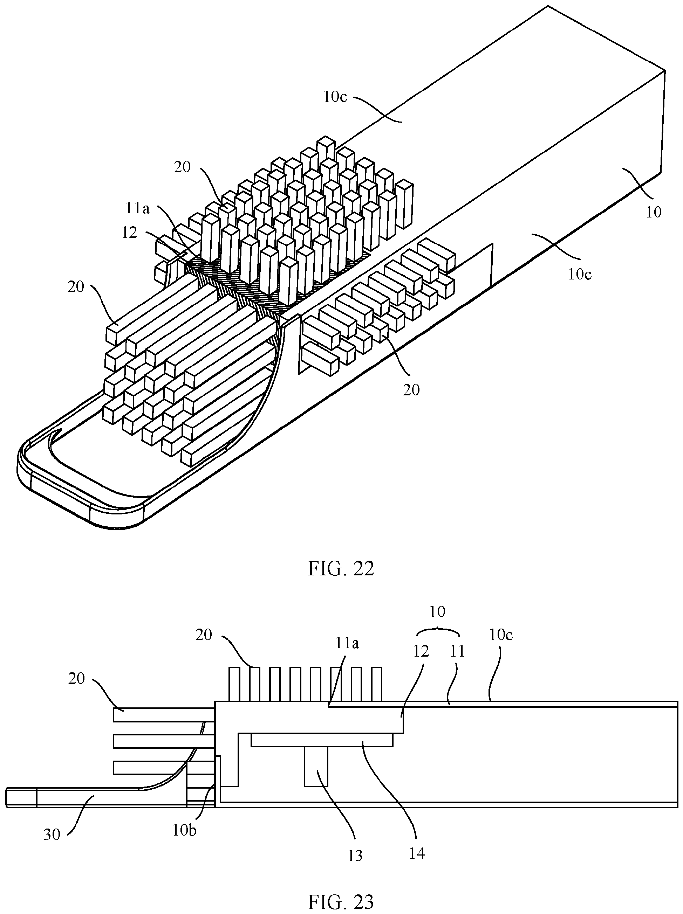

FIG. 22 is a schematic diagram of a structure of an optical module according to an embodiment of this application. FIG. 23 is a cross-sectional view of FIG. 22. As shown in FIG. 22 and FIG. 23, a first opening 11a is located at a connection between an end part of the housing 11 and a side wall of the housing 11. A part of a surface that is of the heat-conducting plate 12 and that is located in the first opening 11a forms a part of the side face 10c of the body 10, and the other part of the surface forms a part of the second end face 10b of the body 10. Apart of the heat dissipation structure 20 located on the second end face 10b of the body 10 is located on a surface of the heat-conducting plate 12, and the other part of the heat dissipation structure 20 is located on a surface of the housing 11. A part of the heat dissipation structure 20 located on the side face 10c of the body 10 is also located on the surface of the heat-conducting plate 12, and the other part of the heat dissipation structure 20 is located on the surface of the housing 11.

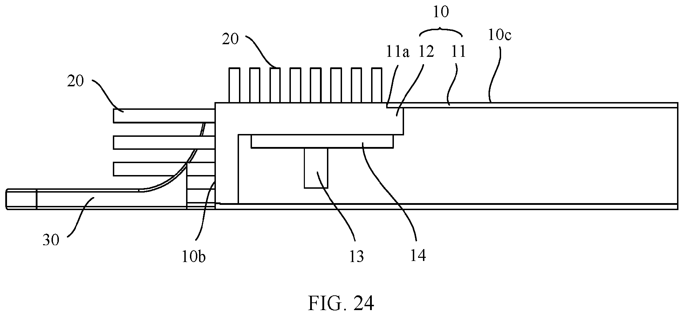

In the optical modules shown in FIG. 20 to FIG. 23, a surface area of the heat-conducting plate 12 exposed by the first opening 11a is small, a part of heat dissipation structures 20 on a part of surfaces of the body 10 are located on the surface of the heat-conducting plate 12, and the other part of the heat dissipation structures 20 are located on the surface of the housing 11. FIG. 24 is a cross-sectional view of an optical module according to an embodiment of this application. As shown in FIG. 24, in the optical module, each heat dissipation structure 20 is completely located on the surface of the heat-conducting plate 12. A surface that is of the heat-conducting plate 12 in the optical module and that is exposed by the first opening 11a is large enough to arrange all heat dissipation structures 20, so that heat on the heat-conducting plate 12 can be directly conducted to the heat dissipation structures 20. Because an exposed surface area of the heat-conducting plate 12 is large, airflow can take away heat from a larger region on the surface of the heat-conducting plate 12. This further improves an overall heat dissipation capability of the optical module.

Optionally, the housing 11 may have a plurality of first openings 11a, so that an exposed area of the heat-conducting plate 12 is larger, and heat dissipation structures 20 on a plurality of surfaces or even each surface can be arranged on the surface of the heat-conducting plate 12.

In some examples, the heat dissipation structure 20 is detachably connected to the heat-conducting plate 12. For example, the heat dissipation structure 20 is connected to the surface of the heat-conducting plate 12 through a screw, a buckle, an adhesive, or the like.

A detachable connection between the heat dissipation structure 20 and the heat-conducting plate 12 facilitates disassembly, assembly, and replacement of the heat dissipation structure 20. In addition, the heat dissipation structure 20 can be reasonably arranged based on a heating situation of the optical module. Therefore, arrangement is flexible.

Optionally, a heat-conducting coating is applied between the heat dissipation structure 20 and the surface of the heat-conducting plate 12, and the heat-conducting coating can be used to fill an air gap between the heat dissipation structure 20 and the surface of the heat-conducting plate 12, to promote heat exchange between the heat-conducting plate 12 and the heat dissipation structure 20, and further improve the heat dissipation capability of the optical module.

In some other examples, the heat dissipation structure 20 located on the surface of the heat-conducting plate 12 and the heat-conducting plate 12 are of an integrally formed structure.

The heat dissipation structure 20 and the heat-conducting plate 12 are designed as the integrally formed structure, so that heat can be conducted from the heat-conducting plate 12 to the heat dissipation structure 20 more quickly.

Optionally, both the heat dissipation structure 20 and the heat-conducting plate 12 are made of a metal material, for example, metal copper, metal aluminum, copper alloy, aluminum alloy, and the like. Copper, aluminum, copper alloy, aluminum alloy, and the like all have good ductility, are convenient to process, and have high thermal conductivity. This is beneficial to heat dissipation of the optical module.

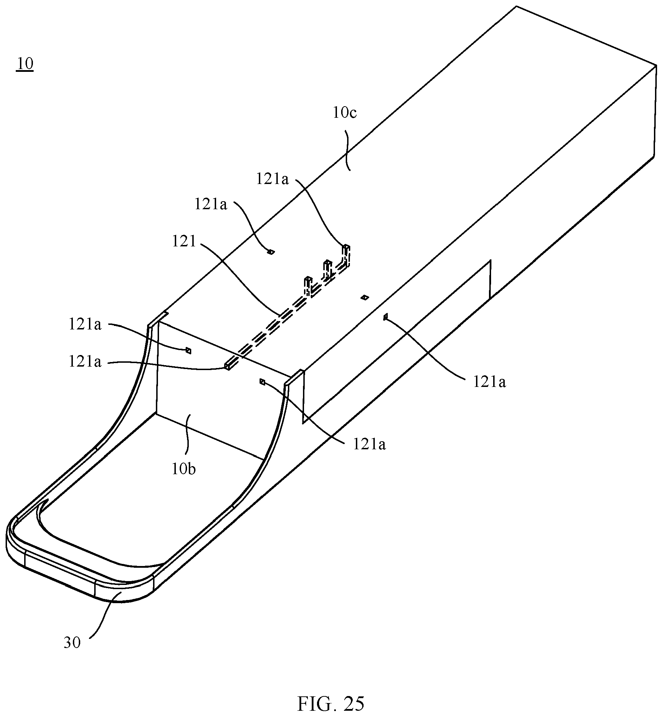

FIG. 25 is a schematic diagram of a structure of a body of an optical module according to an embodiment of this application. As shown in FIG. 25, in the optical module, the body 10 has an airflow channel 121. The airflow channel 121 is shown in dashed lines in FIG. 25. A second opening 121a of the airflow channel 121 is located on the surface of the body 10.

The airflow channel 121 is a hole structure located in the body 10, and an opening of a hole is located on the surface of the body 10. The airflow channel 121 has at least two second openings 121a, and airflow can flow through the inside of the body 10 from the second openings 121a located on the surface of the body 10, to take away heat of the optical module and further improve a heat dissipation capability of the optical module.

In the example shown in FIG. 25, one second opening 121a of the airflow channel 121 is located on the side face 10c of the body 10, and the other second opening 121a is located on the second end face 10b of the body 10. In a working process of the optical module, airflow can enter the body 10 from one second opening 121a, and then flow out from the other second opening 121a. In this process, a portion of heat inside the body 10 is taken away through the airflow.

Optionally, the airflow channel 121 has a plurality of second openings 121a. The plurality of second openings 121a are distributed on the surface of the body 10, so that airflow is easier to flow through the inside of the airflow channel 121, thereby accelerating heat dissipation of the optical module. In some examples, the plurality of second openings 121a may be located on a same surface of the body 10, for example, on the second end face 10b of the body 10. Alternatively, the plurality of second openings 121a may be located on different surfaces of the body 10. For example, a part of the second openings 121a are located on the second end face 10b of the body 10, and the other part of the second openings 121a are located on a same side face 10c of the body 10 or on several side faces 10c of the body 10.

In some examples, the body 10 may have a plurality of airflow channels 121. Some or all of the airflow channels 121 communicate with each other, or the airflow channels 121 are isolated from each other.

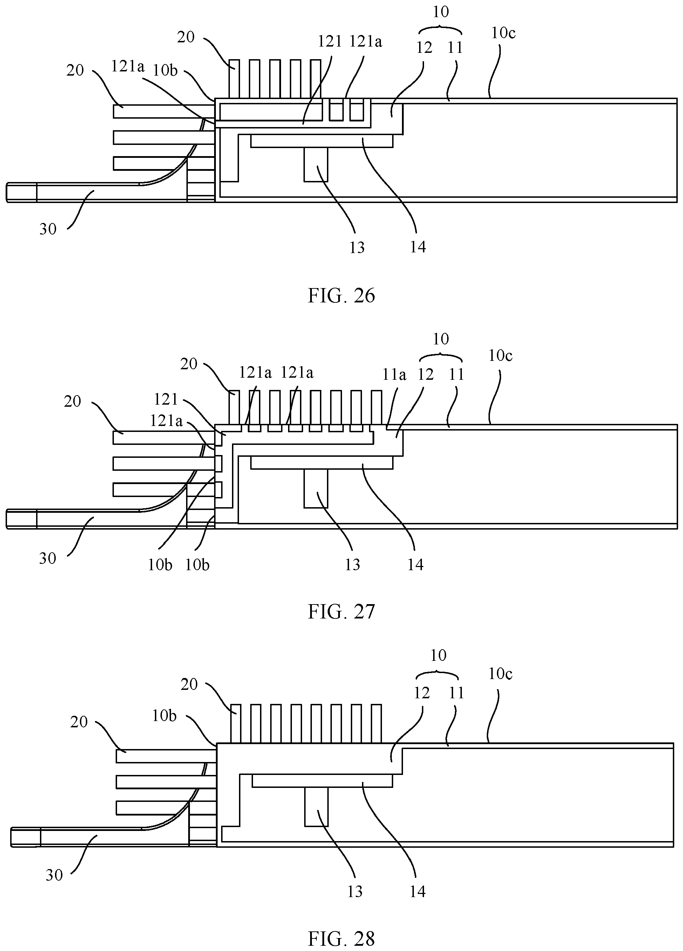

FIG. 26 is a cross-sectional view of an optical module according to an embodiment of this application. As shown in FIG. 26, at least one second opening 121a of the airflow channel 121 is located in a region in which the heat dissipation structure 20 is located. The region in which the heat dissipation structure 20 is located is a region in which the heat dissipation structure 20 is disposed on the surface of the body 10.

The second opening 121a is disposed in the region in which the heat dissipation structure 20 is located, so that the second opening 121a is close to a heat dissipation tooth or a heat dissipation fin. When airflow flows out of the second opening 121a, a portion of heat is also taken away from a surface of the heat dissipation tooth or the heat dissipation fin close to the second opening 121a through the airflow, thereby further accelerating a heat dissipation rate of the optical module. In some examples, the second opening 121 is located between adjacent heat dissipation teeth. In other examples, the second opening 121 is located between adjacent heat dissipation fins.

As shown in FIG. 26, the airflow channel 121 is located in the heat-conducting plate 12 and the housing 11. FIG. 27 is a schematic diagram of a structure of an optical module according to an embodiment of this application. As shown in FIG. 27, in the optical module, the housing 11 has the first opening 11a, and the airflow channel 121 is located in the heat-conducting plate 12. A main heat-generating component inside the optical module is the laser 13, and heat of the laser 13 is conducted to the heat-conducting plate 12 through the cooler 14. As a result, a temperature of the heat-conducting plate 12 is high. A contact area between the heat-conducting plate 12 and air is increased by disposing the airflow channel 121 in the heat-conducting plate 12. In this way, airflow can take away heat of the heat-conducting plate 12 more quickly, to reduce a temperature of the optical module.

FIG. 28 is a schematic diagram of a structure of an optical module according to an embodiment of this application. As shown in FIG. 28, a difference between the optical module and the optical modules shown in FIG. 18 to FIG. 27 lies in that the housing 11 and the heat-conducting plate 12 are of an integrally formed structure. The housing 11 and the heat-conducting plate 12 are disposed as the integrally formed structure. This facilitates heat conduction inside the body 10 to the surface of the body 10, and accelerates heat dissipation of the optical module.

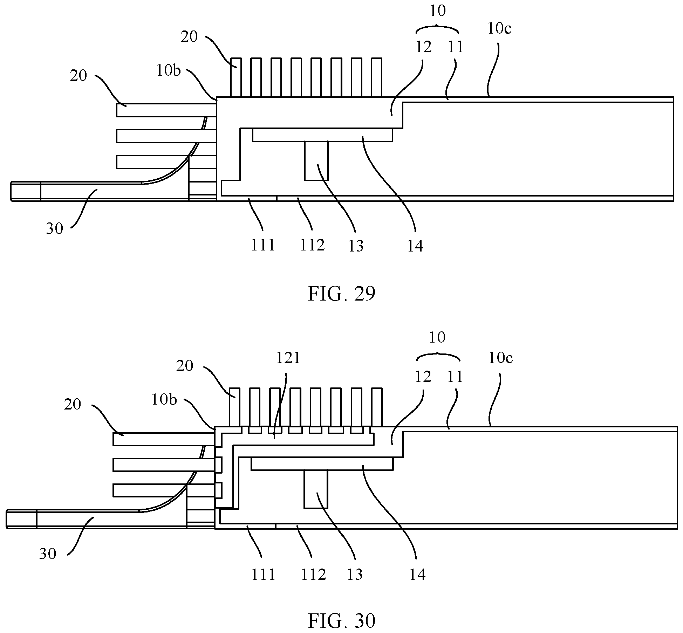

In this example, the housing 11 is of an integral structure. FIG. 29 is a schematic diagram of a structure of an optical module according to an embodiment of this application. As shown in FIG. 29, in this example, the housing 11 includes a first housing 111 and a second housing 112 that are detachable, and the heat-conducting plate 12 and the first housing 111 are of an integrally formed structure.

FIG. 30 is a schematic diagram of a structure of an optical module according to an embodiment of this application. As shown in FIG. 30, in this example, the housing 11 and the heat-conducting plate 12 are of an integrally formed structure, and the body 10 further has the airflow channel 121, to further improve a heat dissipation capability of the optical module.

In some examples, the heat dissipation structure 20, the housing 11, and the heat-conducting plate 12 are of an integrally formed structure, so that heat inside the optical module can be conducted to the heat dissipation structure 20 more quickly.

Optionally, the housing 11 and the heat-conducting plate 12 may be made of a vapor chamber (vapor chamber, VC) material. The housing 11 and the heat-conducting plate 12 are manufactured by using a vapor chamber technology, to further improve a heat dissipation capability of the optical module.

It should be noted that in the examples shown in FIG. 18 to FIG. 30, only an example in which the heat dissipation structure 20 includes a plurality of heat dissipation teeth is used, and in another example, the heat dissipation structure 20 may also include a plurality of heat dissipation fins. In addition, heat dissipation structures 20 of the optical modules shown in FIG. 1 to FIG. 15 and bodies 10 of the optical modules shown in FIG. 18 to FIG. 30 may be freely combined. Only some examples are provided in embodiments of this application.

An embodiment of this application further provides an optical communication device. The optical communication device includes an optical module connector and at least one optical module shown in FIG. 1 to FIG. 30.

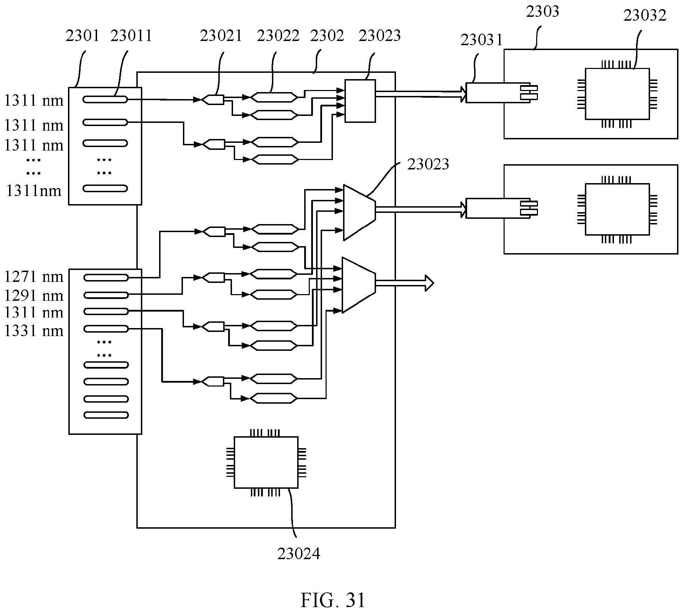

FIG. 31 is a schematic diagram of an optical communication system according to an embodiment of this application. The system is a silicon photonic co-packaged optical communication system. As shown in FIG. 31, the optical communication system includes a light source pool 2301, an optical line terminal 2302, and a plurality of optical network terminals 2303. In FIG. 31, two optical network terminals 2303 are shown as an example, and FIG. 31 schematically shows a partial structure in the optical line terminal 2302 and a partial structure in the optical network terminal 2303.

The light source pool 2301 includes one or more optical modules 23011 that are configured to provide an optical signal of one or more wavelengths. The optical module 23011 is connected to the optical line terminal 2302. For example, the optical module 23011 is inserted into an optical cage on a panel of the optical line terminal 2302, and is connected to an optical module connector in the optical cage. The optical line terminal 2302 includes a plurality of optical power optical splitters 23021, a plurality of optical engines 23022, and a plurality of multiplexers 23023. The optical power optical splitter 23021 is connected to the optical module 23011, the optical power optical splitter 23021 is connected to the optical engine 23022, and the optical engine 23022 is connected to the multiplexer 23023. The multiplexer 23023 is connected to the optical network terminal 2303. A "connection" herein means that optical signal transmission can be performed between two structures that cooperate with each other, and is not limited to an optical fiber connection. For example, that the optical power optical splitter 23021 is connected to the optical engine 23022 includes that the optical power optical splitter 23021 is connected to the optical engine 23022 through an optical fiber, and also includes that the optical engine 23022 is located on a propagation path of an optical signal output by the optical power optical splitter 23021.

The optical line terminal 2302 further includes a first host integrated circuit 2304. The optical network terminal 2303 includes an optical module 23031 and a second host integrated circuit 23032. For example, the optical module 23031 may be a 400G QSFP-DD module.

The light source pool provides an external centralized light source pool for the entire silicon photonic co-packaged optical communication system. The silicon photonic co-packaged optical communication system serves as a preferential way to implement an optical communication module and system with a rate of 25.6 Tbps, 51.2 Tbps or even higher based on 1.6 Tbps and 3.2 Tbps.

The optical module 23011 in this embodiment of this application allows the light source pool to have a larger heat dissipation area, thereby improving a heat dissipation capability of the light source pool, and reducing a requirement on a heat dissipation wind speed and power consumption of the system. In addition, good heat dissipation helps improve reliability of the optical module, prolongs a service life of the optical module, and enables the optical module to adapt to more scenarios.

Unless otherwise defined, a technical term or a scientific term used herein should have a general meaning understood by a person of ordinary skill in the art of this application. In the specification and claims of this application, terms such as "first", "second", and "third" do not indicate any order, quantity, or importance, but are merely used to distinguish different components. Likewise, "a/an", "one", or the like is not intended to indicate a quantity limitation, but indicates that there is at least one. Terms "include", "including", and a similar expression mean that an element or object before "include" or "including" now covers elements or objects listed after "include" or "including" and their equivalents, and other elements or objects are not excluded. "Connection", "connected", or the like is not limited to a physical or mechanical connection, but may include an electrical connection, either a direct connection or an indirect connection. "Up", "down", "left", "right", "top", "bottom", and the like only indicate a relative location relationship, and when an absolute location of a described object changes, the relative location relationship may also change accordingly.

The foregoing descriptions are merely an embodiment of this application, but are not intended to limit this application. Any modification, equivalent replacement, or improvement made within the spirit or principle of this application should fall within the protection scope of this application.

**Claims**

1. An optical module, comprising a body (10) and at least one heat dissipation structure (20), wherein the body (10) has a first end face (10a) and a second end face (10b), the first end face (10a) of the body (10) has at least one of an optical interface and an electrical interface, the second end face (10a) of the body (10) is an end face facing opposite to the first end face (10a), and the at least one heat dissipation structure (20) is located at least on the second end face (10b) and/or a side face (10c) of the body (10).

2. The optical module according to claim 1, wherein the heat dissipation structure (20) comprises a plurality of heat dissipation teeth (21).

3. The optical module according to claim 2, wherein at least a part of the plurality of heat dissipation teeth (21) have a bent shape.

4. The optical module according to claim 3, wherein a heat dissipation tooth (21) with a bent shape is of a segmented structure and comprises a first columnar part (211) and a second columnar part (212), one end of the first columnar part (211) is connected to the body (10), the other end of the first columnar part (211) is connected to one end of the second columnar part (212), and an included angle exists between a length direction of the first columnar part (211) and a length direction of the second columnar part (212).

5. The optical module according to claim 4, wherein the heat dissipation teeth (21) are distributed on the second end face (10b), and second columnar parts (212) of at least a part of the heat dissipation teeth (21) located on the second end face (10b) are connected.

6. The optical module according to claim 4 or 5, wherein the heat dissipation teeth (21) are distributed on the side face (10c) of the body (10).

7. The optical module according to claim 6, wherein second columnar parts (212) of at least a part of the heat dissipation teeth (21) located on the side face (10c) extend in a direction away from the first end face (10a).

8. The optical module according to claim 6 or 7, wherein

    second columnar parts (212) of at least a part of the heat dissipation teeth (21) located on the side face (10c) are connected; and/or the heat dissipation teeth (21) are distributed on the second end face (10b), and second columnar parts (212) of at least a part of the heat dissipation teeth (21) located on the side face (10c) are connected to second columnar parts (212) of at least a part of the heat dissipation teeth (21) located on the second end face (10b).

9. The optical module according to claim 2 or 3, wherein the optical module further comprises a front panel (30), and the front panel (30) is connected to two opposite side faces (10c) of the body (10) and protrudes relative to the second end face (10b).

10. The optical module according to claim 9, wherein heat dissipation teeth (21) are distributed on a first side face (10c') of the body (10), the first side face (10c') is a side face (10c) that is of the body (10) and that is connected to the front panel (30), and at least a part of the heat dissipation teeth (21) located on the first side face (10c') have a bent shape.

11. The optical module according to claim 10, wherein the heat dissipation teeth (21) that are located on the first side face (10c') and that have the bent shape partially overlap an orthographic projection of the front panel (30) on the first side face (10c').

12. The optical module according to claim 10, wherein each of at least a part of the heat dissipation teeth (21) that are located on the first side face (10c') and that have the bent shape is of a segmented structure and comprises a first columnar part (211) and a second columnar part (212), an included angle exists between a length direction of the first columnar part (211) and a length direction of the second columnar part (212), one end of the first columnar part (211) is connected to the body (10), the other end of the first columnar part (211) is connected to one end of the second columnar part (212), and the second columnar part (212) is located on a side that is of the first columnar part (211) and that is close to the front panel (30).

13. The optical module according to claim 12, wherein an orthographic projection, on the first side face (10c'), of a second columnar part (212) of a heat dissipation tooth (21) located on the first side face (10c') partially overlaps the orthographic projection of the front panel (30) on the first side face (10c').

14. The optical module according to claim 12 or 13, wherein a plurality of heat dissipation teeth (21) located on the first side face (10c') are distributed on two sides of the front panel (30).

15. The optical module according to claim 14, wherein a second columnar part (212) of a heat dissipation tooth (21) located on one side of the front panel (30) is connected to a second columnar part (212) of a heat dissipation tooth (21) located on the other side of the front panel (30).

16. The optical module according to any one of claims 12 to 15, wherein each of at least the part of the heat dissipation teeth (21) located on the first side face (10c') further comprises a third columnar part (213), the third columnar part (213) is located on a side that is of the second columnar part (212) and that is close to the first side face (10c'), and one end of the third columnar part (213) is connected to a side wall of the second columnar part (212); and the heat dissipation structure (20) is distributed on a surface of the front panel (30), and heat dissipation teeth (21) located on the surface of the front panel (30) are distributed with at least a part of third columnar parts (213) in a stagger manner.

17. The optical module according to claim 12 or 13, wherein at least one first side face (10c') of the body (10) is provided with a protruding part (101), and the front panel (30) is located between the protruding part (101) and a first columnar part (211) of a heat dissipation tooth (21) on the first side face (10c').

18. The optical module according to any one of claims 4 to 15 and 17, wherein each of at least a part of the heat dissipation teeth (21) further comprises at least one third columnar part (213), the third columnar part (213) is located on a side that is of the second columnar part (212) and that is close to or away from the body (10), and one end of the third columnar part (213) is connected to a side wall of the second columnar part (212).

19. The optical module according to any one of claims 2 to 18, wherein the heat dissipation structure (20) further comprises a bottom plate (201), the bottom plate (201) is located on a surface of the body (10), and the heat dissipation teeth (21) are connected to the bottom plate (201).

**20.** The optical module according to claim 1, wherein the heat dissipation structure (20) comprises a plurality of heat dissipation fins (22).

**21.** The optical module according to claim 20, wherein the heat dissipation fins (22) are distributed on the side face (10c) of the body (10).

**22.** The optical module according to claim 21, wherein

at least a part of the heat dissipation fins (22) located on adjacent side faces (10c) are connected; and/or
the heat dissipation fins (22) are distributed on the second end face (10b), and at least a part of the heat dissipation fins (22) located on the side face (10c) are connected to at least a part of the heat dissipation fins (22) located on the second end face (10b).

**23.** The optical module according to any one of claims 20 to 22, wherein the heat dissipation structure (20) further comprises a bottom plate (201), the bottom plate (201) is located on a surface of the body (10), and the heat dissipation fins (22) are connected to the bottom plate (201).

**24.** The optical module according to any one of claims 1 to 23, wherein the body (10) comprises a first segment (102) and a second segment (103) that are connected, the first end face (10a) is located in the first segment (102), the second end face (10b) is located in the second segment (103), and a cross section of the first segment (102) is smaller than a cross section of the second segment (103).

**25.** The optical module according to any one of claims 1 to 24, wherein the body (10) comprises a housing (11) and a heat-conducting plate (12), and the heat-conducting plate (12) is located in the housing (11) and is connected to the housing (11).

**26.** The optical module according to claim 25, wherein the housing (11) has at least one first opening (11a), and at least a part of the heat-conducting plate (12) is located in the first opening (11a); and the heat dissipation structure (20) is located in the first opening (11a), and is located on a surface of the heat-conducting plate (12).

**27.** The optical module according to claim 26, wherein the heat dissipation structure (20) is detachably connected to the heat-conducting plate (12), or the heat dissipation structure (20) and the heat-conducting plate (12) are of an integrally formed structure.

**28.** The optical module according to any one of claims 25 to 27, wherein the heat dissipation structure (20) is located on a surface of the housing (11).

**29.** The optical module according to claim 28, wherein the heat dissipation structure (20) is detachably connected to the housing (11), or the heat dissipation structure (20) and the housing (11) are of an integrally formed structure.

**30.** The optical module according to any one of claims 25 to 29, wherein an orthographic projection of the heat dissipation structure (20) on the surface of the housing (11) at least partially overlaps an orthographic projection of the heat-conducting plate (12) on the surface of the housing (11).

**31.** The optical module according to any one of claims 25 to 30, wherein the body (10) has an airflow channel (121), and a second opening (121a) of the airflow channel (121) is located on the second end face (10b) of the body (10) and/or the side face (10c) of the body (10).

**32.** The optical module according to claim 31, wherein at least one second opening (121a) of the airflow channel (121) is located in a region in which the heat dissipation structure (20) is located.

**33.** The optical module according to claim 31 or 32, wherein the airflow channel (121) is located in the heat-conducting plate (12).

**34.** The optical module according to any one of claims 25 to 33, wherein the housing (11) and the heat-conducting plate (12) are of an integrally formed structure.

**35.** An optical communication device, comprising an optical module connector and at least one optical module (23011) according to any one of claims 1 to 34.

FIG. 1

FIG. 2

FIG. 3

FIG. 4

FIG. 5

FIG. 6

FIG. 7

FIG. 8

FIG. 9

FIG. 10

FIG. 11

FIG. 12

FIG. 13

FIG. 14

FIG. 15

FIG. 16

FIG. 17

FIG. 18

FIG. 19

FIG. 20

FIG. 21

FIG. 22

FIG. 23

FIG. 24

FIG. 25

FIG. 26

FIG. 27

FIG. 28

FIG. 29

FIG. 30

FIG. 31

## INTERNATIONAL SEARCH REPORT

| | International application No. |
|---|---|
| | **PCT/CN2022/114591** |

**A.  CLASSIFICATION OF SUBJECT MATTER**

G02B 6/42(2006.01)i;  H05K 7/20(2006.01)i

According to International Patent Classification (IPC) or to both national classification and IPC

**B.  FIELDS SEARCHED**

Minimum documentation searched (classification system followed by classification symbols)

G02B6,H05K7

Documentation searched other than minimum documentation to the extent that such documents are included in the fields searched

Electronic data base consulted during the international search (name of data base and, where practicable, search terms used)

CNABS, CNTXT, ENTXTC, VEN, CNKI: 光模块, 收发, 笼子, 散热, 冷却, 齿, 鳍片, 翅片, 柱, 端面, 前面, 外, 侧, 空间, optic +, module?, cage?, transceiver, heat, radiat+, sink, cool+, fin?, column?, surface, out+, side+, space+

**C.  DOCUMENTS CONSIDERED TO BE RELEVANT**

| Category* | Citation of document, with indication, where appropriate, of the relevant passages | Relevant to claim No. |
|---|---|---|
| X | CN 110764200 A (LITUREX TECHNOLOGY (GUANGZHOU) CO., LTD.) 07 February 2020 (2020-02-07)<br>    description, paragraphs 26-40, and figures 1-7 | 1-35 |
| X | CN 113031173 A (ACCELINK TECHNOLOGIES CO., LTD.) 25 June 2021 (2021-06-25)<br>    description, paragraphs 25-54, and figures 1-6 | 1-35 |
| X | CN 108802919 A (SOURCE PHOTONICS INC.) 13 November 2018 (2018-11-13)<br>    description, paragraphs 33-67, and figures 1-6 | 1-35 |
| A | CN 102933064 A (HUAWEI TECHNOLOGIES CO., LTD.) 13 February 2013 (2013-02-13)<br>    entire document | 1-35 |
| A | JP 3207656 U (FENG WENBIAO) 24 November 2016 (2016-11-24)<br>    entire document | 1-35 |
| A | CN 208047116 U (WUHAN ETERNAL TECHNOLOGIES CO., LTD.) 02 November 2018 (2018-11-02)<br>    entire document | 1-35 |
| A | CN 105307450 A (ZTE CORP.) 03 February 2016 (2016-02-03)<br>    entire document | 1-35 |

☐ Further documents are listed in the continuation of Box C.  ☑ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **11 November 2022** | **22 November 2022** |

| Name and mailing address of the ISA/CN | Authorized officer |
|---|---|
| **China National Intellectual Property Administration (ISA/ CN)**<br>**No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2022/114591**

| Patent document cited in search report | | | Publication date (day/month/year) | Patent family member(s) | | | Publication date (day/month/year) |
|---|---|---|---|---|---|---|---|
| CN | 110764200 | A | 07 February 2020 | CN | 210835352 | U | 23 June 2020 |
| CN | 113031173 | A | 25 June 2021 | None | | | |
| CN | 108802919 | A | 13 November 2018 | US | 2019113698 | A1 | 18 April 2019 |
| CN | 102933064 | A | 13 February 2013 | None | | | |
| JP | 3207656 | U | 24 November 2016 | None | | | |
| CN | 208047116 | U | 02 November 2018 | None | | | |
| CN | 105307450 | A | 03 February 2016 | RU | 2017100656 | A | 19 July 2018 |
| | | | | EP | 3145287 | A1 | 22 March 2017 |
| | | | | WO | 2015192499 | A1 | 23 December 2015 |

Form PCT/ISA/210 (patent family annex) (January 2015)

**REFERENCES CITED IN THE DESCRIPTION**

**Patent documents cited in the description**

- CN 202111124268

- CN 202210626425